# EUROPEAN PATENT APPLICATION

(11) **EP 4 822 892 A1**
(43) Date of publication of application: **14.10.2026**
(21) Application number: 24900319.5
(22) Date of filing: 24.10.2024
(51) Int. Cl.: H01Q 1/52, H01Q 17/00, H05K 9/00

(54) **STRUCTURE AND STRUCTURE MANUFACTURING METHOD**

(30) Priority: 04.12.2023 JP 2023204513
(71) Applicant: FUJIFILM Corporation, Tokyo 106-8620 (JP)
(72) Inventor: MASUDA Seiya, Haibara-gun, Shizuoka 421-0396 (JP)
(74) Representative: HGF
(86) International application number: PCT/JP2024/037867
(87) International publication number: WO 2025/121023

(57) **Abstract**

Provided is a structure that includes a transmitting antenna element with a high antenna gain and is configured to reduce the influence of electromagnetic waves between the transmitting antenna element and a receiving antenna element. Also provided is a method for producing the structure. The structure includes: the substrate; the transmitting antenna element and the receiving antenna element that are disposed on one surface of the substrate; and a plurality of magnetic material portions extending in a thickness direction of the substrate within the substrate and disposed so as to be spaced apart from each other.

## Description

### BACKGROUND OF THE INVENTION

### 1. Field of the Invention

The present invention relates to a structure in which a transmitting antenna element and a receiving antenna element are disposed on one surface of a substrate and a method for producing the structure and more particularly to a structure having the function of shielding electromagnetic waves between the transmitting antenna element and the receiving antenna element and a method for producing the structure.

### 2. Description of the Related Art

In modern radio frequency (RF) devices such as motion sensors and autonomous driving radars, the transmitting and receiving antennas are disposed adjacent to each other. In this configuration, space-efficient and effective electromagnetic shielding between the transmitting and receiving antennas is required in order to reduce the influence of radio waves from the transmitting antenna and to improve the sensitivity of the receiving antenna.

For example, JP2023-145382A discloses a signal transmitting/receiving device in which a support and an alternating multilayer unit including 5 to 1000 alternately stacked A and B layers having different electroconductivities are disposed in a central portion between the transmitting antenna and the receiving antenna. It is stated that the alternating multilayer unit contains an electromagnetic wave-absorbing material.

### SUMMARY OF THE INVENTION

In JP2023-145382A, the alternating multilayer unit is disposed in the central portion between the transmitting antenna and the receiving antenna, but its electromagnetic wave shielding performance is insufficient. Therefore, increasing the power of the transmitting element leads to a reduction in the sensitivity of the receiving element.

It is an object of the invention to provide a structure that includes a transmitting antenna element with a high antenna gain and is configured to reduce the influence of electromagnetic waves between the transmitting antenna element and a receiving antenna element and to provide a method for producing the structure.

The above object can be achieved by the following aspects.

Invention [1] is a structure including: a substrate; a transmitting antenna element and a receiving antenna element that are disposed on one surface of the substrate; and a plurality of magnetic material portions extending in a thickness direction of the substrate within the substrate and disposed so as to be spaced apart from each other.

Invention [2] is the structure according to invention [1], wherein, when the substrate is viewed in a direction normal to the one surface of the substrate, the magnetic material portions are arranged around the transmitting antenna element and around the receiving antenna element.

Invention [3] is a structure including: a substrate; a transmitting antenna element and a receiving antenna element that are disposed on one surface of the substrate; a magnetic material wall portion disposed on the one surface of the substrate and arranged in a region excluding a region including the transmitting antenna element and the receiving antenna element so as to surround the transmitting antenna element and the receiving antenna element; and a magnetic material portion disposed on another surface of the substrate.

Invention [4] is the structure according to invention [3], wherein the magnetic material portion is disposed so as to cover an entire surface on the another surface of the substrate.

Invention [5] is the structure according to any one of inventions [1] to [4], wherein the magnetic material portion contains magnetic material particles.

Invention [6] is a structure including: a substrate; a transmitting antenna element and a receiving antenna element that are disposed on one surface of the substrate; and a magnetic material layer disposed on the substrate, wherein, when the substrate is viewed in a direction normal to the one surface of the substrate, the magnetic material layer has a first magnetic material portion disposed between the transmitting antenna element and the receiving antenna element, a second magnetic material portion disposed so as to sandwich the transmitting antenna element together with the first magnetic material portion, a third magnetic material portion disposed so as to sandwich the receiving antenna element together with the first magnetic material portion, and a fourth magnetic material portion connecting the first magnetic material portion, the second magnetic material portion, and the third magnetic material portion, and wherein the fourth magnetic material portion is disposed so as to avoid a region in which the transmitting antenna element is disposed and a region in which the receiving antenna element is disposed.

Invention [7] is the structure according to invention [6], wherein the magnetic material layer is disposed on the one surface of the substrate.

Invention [8] is the structure according to invention [6], wherein the magnetic material layer is disposed on another surface of the substrate.

Invention [9] is the structure according to invention [2], wherein, in the magnetic material layer, the first magnetic material portion, the second magnetic material portion, and the third magnetic material portion are linear members extending in a one direction, wherein the fourth magnetic material portion is a linear member extending in a another direction orthogonal to the one direction, wherein the first magnetic material portion, the second magnetic material portion, and the third magnetic material portion are spaced apart from each other and disposed parallel to each other, and wherein the fourth magnetic material portion connects the first magnetic material portion, the second magnetic material portion, and the third magnetic material portion at their end portions with respect to the one direction.

Invention [10] is the structure according to any one of inventions [6] to [9], wherein the magnetic material layer contains magnetic material particles.

Invention [11] is the structure according to any one of inventions [1] to [5], wherein the magnetic material portion has a complex relative magnetic permeability µ with a real part µ' and an imaginary part µ", and the imaginary part µ" is 0.01 to 10 at a frequency of 1 to 40 GHz and is 0.01 to 5 at a frequency of higher than 40 and 100 GHz or less.

Invention [12] is the structure according to any one of inventions [6] to [10], wherein the magnetic material layer has a complex relative magnetic permeability µ with a real part µ' and an imaginary part µ", and the imaginary part µ" is 0.01 to 10 at a frequency of 1 to 40 GHz and is 0.01 to 5 at a frequency of higher than 40 and 100 GHz or less.

Invention [13] is the structure according to any one of inventions [1] to [11] further including an interposer stacked on the substrate.

Invention [14] is the structure according to any one of inventions [5] to [9], wherein the magnetic material particles contain at least one metal element selected from the group consisting of Ni, Co, and Fe and have a number average particle diameter of 20 nm to 50 µm.

Invention [15] is the structure according to any one of inventions [10] to [13], wherein the magnetic material particles contain at least one metal element selected from the group consisting of Ni, Co, and Fe and have a number average particle diameter of 20 nm to 50 µm.

Invention [16] is a method for producing a structure, the method including the steps of: forming, in a substrate, a plurality of through holes passing through the substrate in a thickness direction thereof; filling the through holes with magnetic material particles; and forming a transmitting antenna element and a receiving antenna element on the substrate.

The present invention can provide a structure that includes a transmitting antenna element with a high antenna gain and is configured to reduce the influence of electromagnetic waves between the transmitting antenna element and the receiving antenna element and can provide a method for producing the structure.

### BRIEF DESCRIPTION OF THE DRAWINGS

Fig. 1 is a schematic perspective view showing a first example of a structure according to an embodiment of the invention;
Fig. 2 is a schematic plan view showing the first example of the structure according to the embodiment of the invention;
Fig. 3 is a schematic cross-sectional view showing the first example of the structure according to the embodiment of the invention;
Fig. 4 is a schematic cross-sectional view showing one step in a method for producing the first example of the structure according to the embodiment of the invention;
Fig. 5 is a schematic cross-sectional view showing another step in the method for producing the first example of the structure according to the embodiment of the invention;
Fig. 6 is a schematic cross-sectional view showing another step in the method for producing the first example of the structure according to the embodiment of the invention;
Fig. 7 is a schematic cross-sectional view showing a second example of the structure according to the embodiment of the invention;
Fig. 8 is a schematic perspective view showing a third example of the structure according to the embodiment of the invention;
Fig. 9 is a schematic plan view showing the third example of the structure according to the embodiment of the invention;
Fig. 10 is a schematic cross-sectional view showing the third example of the structure according to the embodiment of the invention;
Fig. 11 is a schematic cross-sectional view showing a modification of the third example of the structure according to the embodiment of the invention;
Fig. 12 is a schematic perspective view showing a fourth example of the structure according to the embodiment of the invention;
Fig. 13 is a schematic plan view showing the fourth example of the structure according to the embodiment of the invention;
Fig. 14 is a schematic perspective view showing a modification of the fourth example of the structure according to the embodiment of the invention;
Fig. 15 is a schematic illustration showing the arrangement positions of a substrate, a transmitting antenna element, and a receiving antenna element;
Fig. 16 is a schematic perspective view showing a structure having shape 6;
Fig. 17 is a schematic plan view showing the structure having shape 6;
Fig. 18 is a schematic perspective view showing a structure having shape 7;
Fig. 19 is a schematic plan view showing the structure having shape 7; and
Fig. 20 is a schematic perspective view showing a structure having shape 8.

### DESCRIPTION OF THE PREFERRED EMBODIMENT

A structure of the present invention and a method for producing the structure will be described in detail below with reference to preferred embodiments shown in the accompanying drawings.

The drawings described below are provided for illustrative purposes in explaining the invention, and the invention is not limited to these drawings.

In the drawings described below, illustrations of electric circuits around a transmitting antenna element and a receiving antenna element, wiring lines, etc. are omitted.

In the following description, a numerical range represented using "to" includes the numerical values before and after the "to." For example, when ε is in the range of a numerical value ε_{α} to a numerical value ε_{β,} the range of ε includes the numerical value ε_{α} and the numerical value ε_{β} and is represented by ε_{α} ≤ ε ≤ ε_{β} using mathematical symbols.

Specific angles, parallelism, and orthogonality may include errors within the tolerances generally allowed in the relevant technical field, unless otherwise specified. In addition, temperatures may include errors within the tolerances generally allowed in the relevant technical field, unless otherwise specified.

### First example of structure

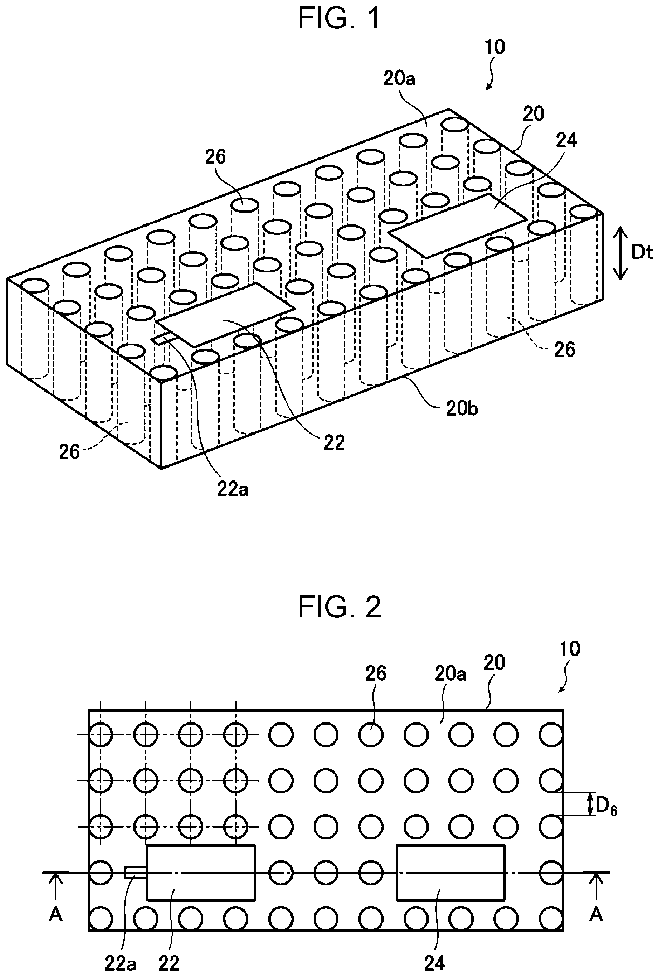

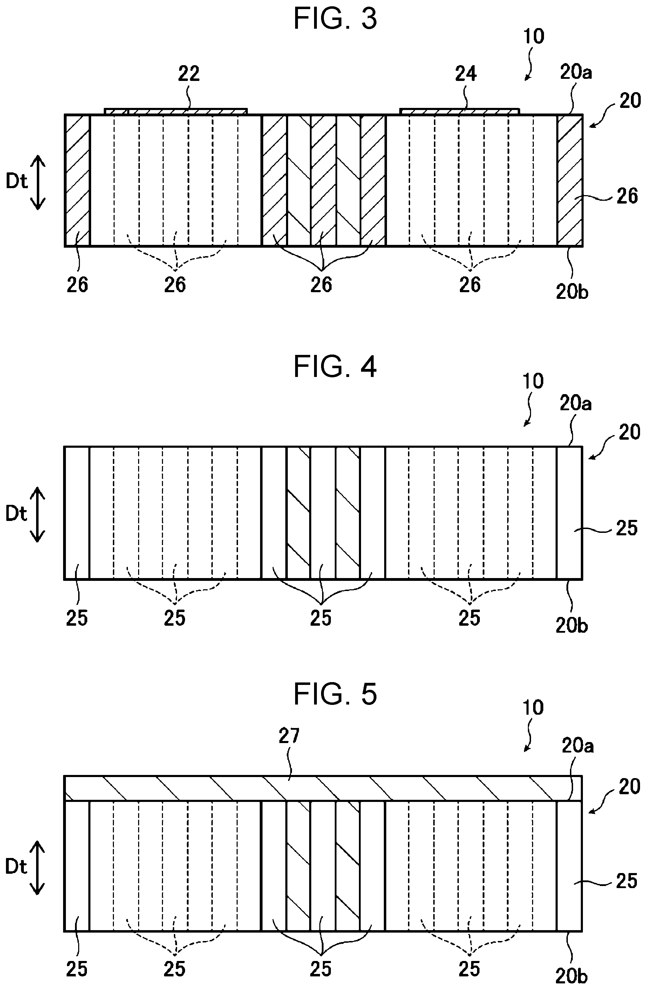

Fig. 1 is a schematic perspective view showing a first example of the structure according to the embodiment of the invention. Fig. 2 is a schematic plan view showing the first example of the structure according to the embodiment of the invention. Fig. 3 is a schematic cross-sectional view showing the first example of the structure according to the embodiment of the invention. The schematic cross-sectional view shown in Fig. 3 is taken along line A-A in Fig. 2.

The structure 10 has a substrate 20 and further has a transmitting antenna element 22 and a receiving antenna element 24 that are disposed on a front surface 20a of the substrate 20.

The structure 10 has a plurality of magnetic material portions 26 extending in the thickness direction Dt of the substrate 20 within the substrate 20 and disposed so as to be spaced apart from each other. The plurality of magnetic material portions 26 are disposed parallel to each other, and their lengths in the thickness direction Dt are the same.

The magnetic material portions 26 are columnar and independent of one another within the substrate 20. As shown in Fig. 2, when the substrate 20 is viewed in a direction normal to the front surface 20a, the magnetic material portions 26 are disposed around the transmitting antenna element 22 and around the receiving antenna element 24 within the substrate 20. Specifically, as shown in Figs. 2 and 3, no magnetic material portions 26 are disposed below the transmitting antenna element 22 and the receiving antenna element 24. The normal direction is a direction parallel to the thickness direction Dt. For example, the magnetic material portions 26 are arranged in a lattice pattern with interior angles of 90° on the front surface 20a of the substrate 20, as shown in Fig. 2.

The front surface 20a side of the substrate 20 is one surface side of the substrate 20, and the back surface side of the substrate 20 is another surface of the substrate 20. The front surface 20a of the substrate 20 is the one surface, and the back surface 20b of the substrate 20 is the another surface.

The substrate 20 functions as a support for the structure 10, and the transmitting antenna element 22 and the receiving antenna element 24 are disposed on the substrate 20. The plurality of magnetic material portions 26 are arranged within the substrate 20.

The substrate 20 is formed, for example, of polytetrafluoroethylene (PTFE), polyimide, Flame Retardant (FR)-4, FR-5, Composite epoxy material-3 (CEM-3), etc.

The transmitting antenna element 22 is an antenna element that emits signals (electromagnetic waves) and has a feeding point 22a. The feeding point 22a of the transmitting antenna element 22 is electrically connected to a transmitting circuit (not shown), and a high-frequency current is to be supplied to the feeding point 22a. The receiving antenna element 24 is an antenna element that receives signals (electromagnetic waves) and is electrically connected to a receiving circuit (not shown). The transmitting antenna element 22 and the receiving antenna element 24 will be described later in detail.

The magnetic material portions 26 provide electromagnetic wave shielding between the transmitting antenna element 22 and the receiving antenna element 24. The magnetic material portions 26 are columnar. However, no particular limitation is imposed on the shape of the magnetic material portions 26, and the magnetic material portions 26 may be, for example, cylindrical or prismatic. In Figs. 1 and 2, the magnetic material portions 26 are cylindrical. The shape of the magnetic material portions 26 in a cross section orthogonal to the thickness direction Dt, which is an extending direction of the magnetic material portion 26, is determined by the shape of the openings of through holes described later. In a case where the openings of the through holes are circular, the magnetic material portions 26 are cylindrical.

In a case where the transmitting antenna element 22 and the receiving antenna element 24 each have a quadrilateral outer shape, the diameter of each magnetic material portion 26 is, for example, preferably 1/3 to 1/20 of the length of the shortest side of the quadrilateral.

In a case where the magnetic material portions 26 are polygonal prisms, the equivalent circle diameter of the polygon corresponds to the diameter of each magnetic material portion 26.

Regarding the arrangement positions of the magnetic material portions 26, the ratio of the diameter of the magnetic material portions 26 to the separation distance between adjacent magnetic material portions 26 is, for example, within the range of 1:0.2 to 1:3, and the magnetic material portions 26 may be arranged not only in a lattice pattern with interior angles of 90° but also in a hexagonal lattice pattern with interior angles of 60°, i.e., in a honeycomb pattern. Regarding the arrangement of the magnetic material portions 26, no particular limitation is imposed on the separation distance between adjacent magnetic material portions 26 so long as the magnetic material portions 26 do not adversely affect the mechanical strength and do not interfere with wiring lines adjacent to the magnetic material portions 26.

As described later, through holes 25 (see Fig. 4) used to form the magnetic material portions 26 are formed in the substrate 20. The arrangement positions of the through holes 25 are the same as the arrangement positions of the magnetic material portions 26.

The magnetic material portions 26 will be described later in detail.

As shown in Figs. 1 to 3, the transmitting antenna element 22 and the receiving antenna element 24 are disposed on the front surface 20a of the substrate 20, and the plurality of magnetic material portions 26 extending in the thickness direction Dt are disposed within the substrate 20. Therefore, while the output power of the receiving antenna element 24 is maintained, the influence of electromagnetic waves on the transmitting antenna element 22 and the receiving antenna element 24 can be reduced. Specifically, the transmitting antenna element has high antenna gain, and the influence of the electromagnetic field between the transmitting antenna element and the receiving antenna element is reduced.

### Transmitting antenna element and receiving antenna element

For example, various antennas usable in the frequency band of 1 GHz to 1000 GHz can be used as the transmitting antenna element 22 and the receiving antenna element 24. The transmitting antenna element 22 has the feeding point 22a, as described above.

The transmitting antenna element 22 and the receiving antenna element 24 used may be, for example, patch antennas, dipole antennas, or array antennas.

The transmitting antenna element 22 and the receiving antenna element 24 are formed, for example, of copper or aluminum. The thickness of the antennas is preferably 20 µm to 50 µm. For example, in a case where a printed circuit board such as one of Flame Retardant Type 1 to Type 5 (FR-1 to FR-5) is used, the thickness of the copper wiring lines is specified by the relevant standards, and the thickness of the antennas is also determined according to the thickness of the copper wiring lines. Alternatively, the thickness of the antennas may be determined according to the thickness of copper foil in a copper-clad laminate specified in Japanese Industrial Standards (JIS) C 6484:2005 (see Table 6 etc. in JIS C 6484: 2005). Moreover, in a case where the antennas are formed using copper by electrolytic plating, the thickness of the antennas is preferably the thickness of the film that can be formed by electrolytic plating.

### Magnetic material portions

The magnetic material portions 26 have a complex relative magnetic permeability µ with a real part µ' and an imaginary part µ". The imaginary part µ" is preferably 0.01 to 10 at a frequency of 1 to 40 GHz and is 0.01 to 5 at a frequency of higher than 40 GHz and 100 GHz or less.

The magnetic material portions 26 contain magnetic material particles (not shown). The magnetic material particles enable the magnetic material portions 26 to exhibit sufficient shielding performance against electromagnetic waves in a frequency range of several tens of GHz. Preferably, the magnetic material particles contain at least one metal element selected from the group consisting of Ni, Co, and Fe and have a number average particle diameter of 20 nm to 50 µm, as described later.

The real part µ' and imaginary part µ" of the complex relative magnetic permeability µ of the magnetic material portions can be measured as follows.

The measurement devices used are a vector network analyzer available from Keysight (product name: N5225B) and horn antennas available from KEYCOM Corporation (product names: RH12S23 and RH06S10). Next, the S parameters are measured using the free space method with the incident angle set to 0° and the sweep frequency range set to 0.025 GHz. Specifically, with one flat surface of each magnetic material portion directed toward the incident side, the S parameters are measured at 0.1 GHz intervals to thereby determine the permeabilities (µ' and µ") at 1 GHz to 40 GHz. Then the sweep frequency range is changed to determine the permeabilities (µ' and µ") at higher than 40 GHz and 100 GHz or less.

The magnetic permeability of a material is the rate of change in magnetic flux density (B) when a magnetic field (H) is applied to the material and is represented by the following formula. $μ = B / H$

A magnetic material allows a large amount of magnetic flux to pass therethrough. In contrast, in a non-magnetic material, the magnetic flux does not change, and its magnetic permeability is 1. The magnetic permeability is represented by the following formula. j in the following formula is the imaginary unit.$μ = μ ' \left(real part\right) - j \times μ " \left(imaginary part\right)$

Electromagnetic waves induce an electric current whose direction reverses at high frequency. In this case, the real part means the ability of the magnetic material to generate a high magnetic flux density, and the imaginary part µ" represents energy loss. Specifically, the magnetic moments of the crystals in the magnetic material are directed toward the direction of the magnetic field generated by the high frequency waves. However, when the magnetic moments reverse, a delay in reversal time or an energy loss (energy conversion into heat) occurs.

At high frequencies, the change in magnetic moments in the magnetic material cannot follow the change in the electromagnetic field applied from the outside, and significant energy loss occurs. This effect is used to absorb electromagnetic waves.

The structure 10 is used, for example, for motion sensors and radars for automobiles.

Although not illustrated, the structure 10 may, for example, be mounted on a substrate together with an analog/digital (A/D) circuit, a memory, an application specific integrated circuit (ASIC), etc. The A/D circuit, the memory, and the ASIC are composed, for example, of various semiconductor elements.

The structure 10 is configured as described above and may also be used together with various circuits, elements, etc. such as radio frequency (RF) circuits, power amplifiers for transmission, low-noise amplifiers for reception, integrated passive elements, switches, and phase shifters that are included in mobile communication terminals such as smartphones and wireless communication modules.

The A/D circuit is configured to convert analog signals to digital signals, and a well-known A/D converter can be used. The A/D circuit converts the received signal received by the array antenna to a digital signal.

The ASIC is configured to obtain the original data or signal transmitted to the array antenna from the digital signal converted from the received signal. The ASIC generates transmission data or a transmission signal in digital form. No particular limitation is imposed on the function of the ASIC, and the function is appropriately determined according to the intended application etc. The A/D circuit converts the transmission data or transmission signal generated in the ASIC to an analog signal that can be transmitted from the transmitting antenna element.

The memory stores the transmission data or transmission signal generated in the ASIC, the digitized received signal received by the array antenna, etc. The memory used is, for example, a volatile memory such as a dynamic random access memory (DRAM) and is preferably a high bandwidth memory (HBM).

The magnetic material portions 26 reduce electromagnetic interference on the A/D circuit, the memory, and the ASIC induced by electromagnetic waves generated by the transmitting antenna element. In this manner, the A/D circuit, the memory, and the ASIC can operate normally with no interruption and are prevented from malfunctioning.

By controlling the absorption of electromagnetic waves using the magnetic material portions 26, the directivity of the antenna output can be enhanced. Moreover, by inserting a magnetic material as a structural member inside the structure of a wafer level package, the degree of integration and performance of the structure can be increased.

### Method for producing first example of structure

Figs. 4 to 6 are schematic cross-sectional views showing, step by step, a method for producing a first example of the structure according to the embodiment of the invention. In Figs. 4 to 6, the same components as those in Figs. 1 to 3 are denoted by the same reference numerals, and their detailed description will be omitted.

As shown in Fig. 4, a plurality of through holes 25 are formed in the substrate 20 so as to pass therethrough in the thickness direction Dt. No through holes 25 are formed in a formation region of the transmitting antenna element 22 and a formation region of the receiving antenna element 24 that have previously been set on the front surface 20a of the substrate 20. Therefore, no magnetic material portions 26 are formed below the transmitting antenna element 22 and the receiving antenna element 24.

No particular limitation is imposed on the method for forming the through holes 25. For example, the through holes 25 are formed using a drill. The through holes 25 are used to form the magnetic material portions 26.

Next, a spraying method, an inkjet method, or a screen printing method, for example, is used to dispose a composition 27 containing magnetic material particles on the front surface 20a of the substrate 20, as shown in Fig. 5.

The composition 27 may contain, in addition to the magnetic material particles, a dispersing agent, a curing agent, etc.

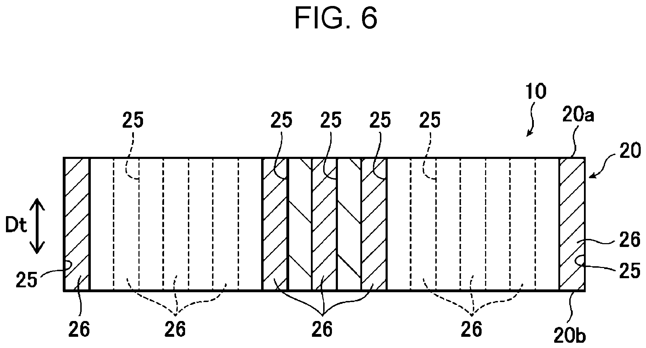

Next, for example, the composition 27 shown in Fig. 5 is drawn in by suction from the back surface 20b of the substrate 20 and introduced into the through holes 25 to fill the through holes 25 with the magnetic material particles. Next, the substrate 20 is heat-treated at a preset temperature for a preset time to heat-cure the composition 27 drawn in the through holes 25, and the magnetic material portions 26 are thereby formed in the substrate 20, as shown in Fig. 6.

Next, a copper film (not shown) is formed, for example, by a plating method. Next, photolithography is applied to the copper film to form the transmitting antenna element 22 and the receiving antenna element 24 in the preset formation region for the transmitting antenna element 22 and the preset formation region for the receiving antenna element 24, respectively, on the front surface 20a of the substrate 20, as shown in Fig. 3.

Before the formation of the through holes 25 in the substrate 20, wiring lines to be connected to the transmitting antenna element 22 and the receiving antenna element 24 are formed.

### Second example of structure

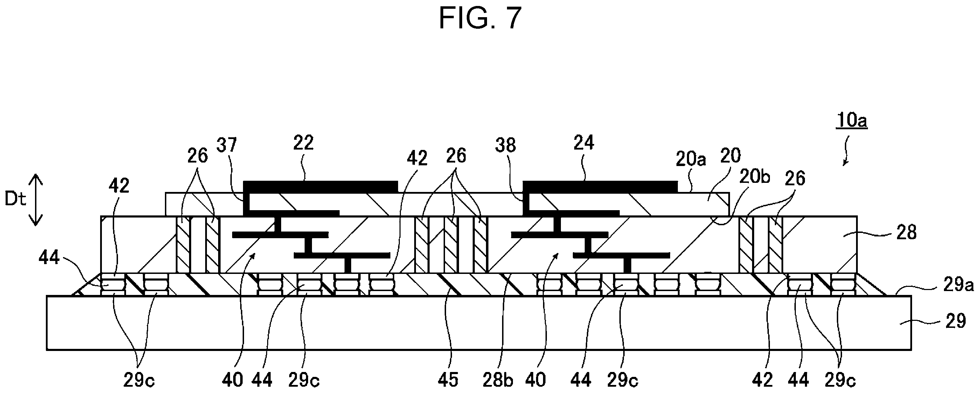

Fig. 7 is a schematic cross-sectional view showing a second example of the structure according to the embodiment of the invention. In Fig. 7, the same components as those in Figs. 1 to 3 are denoted by the same reference numerals, and their detailed description will be omitted.

The structure 10a shown in Fig. 7 differs from the structure 10 shown in Figs. 1 to 3 in that the structure 10a has an interposer 28, and the other configurations are the same as those of the structure 10 shown in Figs. 1 to 3. In the structure 10a shown in Fig. 7, the magnetic material portions 26 disposed in the substrate 20 are omitted from the illustration. A wiring line 37 electrically connected to the transmitting antenna element 22 is disposed in the substrate 20. Moreover, a wiring line 38 electrically connected to the receiving antenna element 24 is disposed in the substrate 20.

The structure 10a shown in Fig. 7 has the interposer 28 stacked on the substrate 20. More specifically, in the structure 10a, the interposer 28 is stacked on the back surface 20b of the substrate 20. The interposer 28 is configured to electrically connect the structure 10 to a circuit board 29. For example, wiring line layers 40 are disposed inside the interposer 28 to establish electrical continuity in the thickness direction Dt. The wiring line 37 electrically connected to the transmitting antenna element 22 is electrically connected to a wiring line layer 40. The wiring line 38 electrically connected to the receiving antenna element 24 is electrically connected to another wiring line layer 40.

The interposer 28 functions also as an electromagnetic wave shielding member. A plurality of magnetic material portions 26 extending in the thickness direction Dt and spaced apart from each other are formed in the interposer 28. The interposer 28 is formed of silicon or glass.

A plurality of connection terminals 42 are disposed on the back surface 28b of the interposer 28. Connection terminals 29c are disposed on the front surface 29a of the circuit board 29. The connection terminals 42 of the interposer 28 are electrically connected to the respective connection terminals 29c of the circuit board 29 through, for example, solder balls 44. In this manner, the interposer 28 is electrically connected to the circuit board 29.

An underfill layer 45 is disposed between the back surface 28b of the interposer 28 and the front surface 29a of the circuit board 29. The underfill layer 45 surrounds the solder balls 44. The underfill layer 45 allows the interposer 28 to be firmly connected to the circuit board 29.

For example, an electronic circuit having a specific function, wiring lines, etc. are formed on the circuit board 29. However, no particular limitation is imposed on the structure of the circuit board 29. Various semiconductor elements may be disposed on the circuit board 29.

In the structure 10a, as in the structure 10 described above, the transmitting antenna element 22 has high antenna gain, and the influence of the electromagnetic field is effectively reduced between the transmitting antenna element 22 and the receiving antenna element 24. In addition to the above, the influence of electromagnetic field on the circuit board 29 can be reduced, as shown in Fig. 7.

### Third example of structure

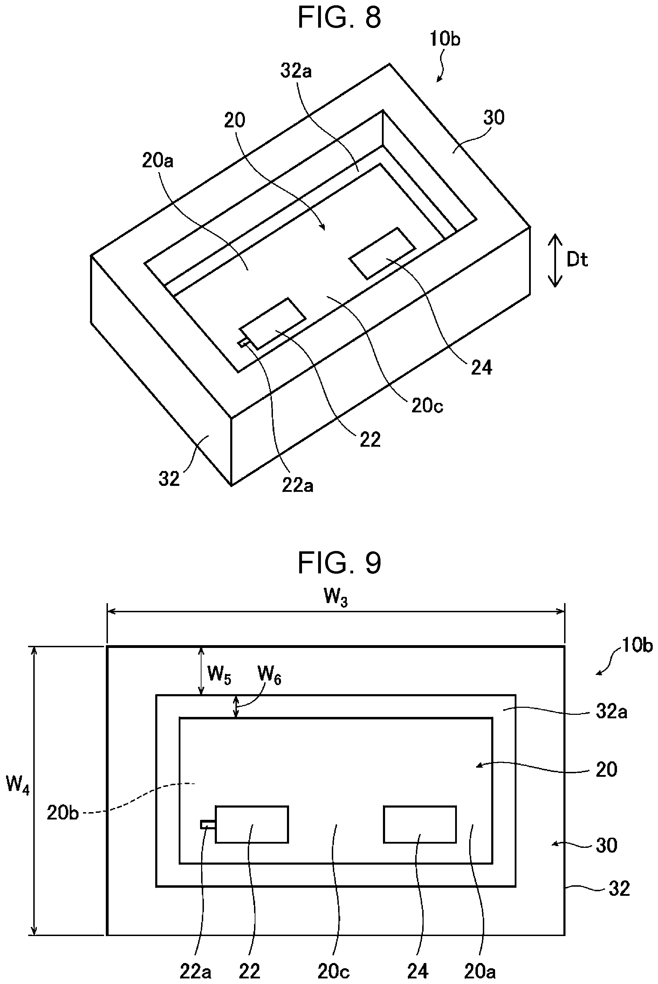

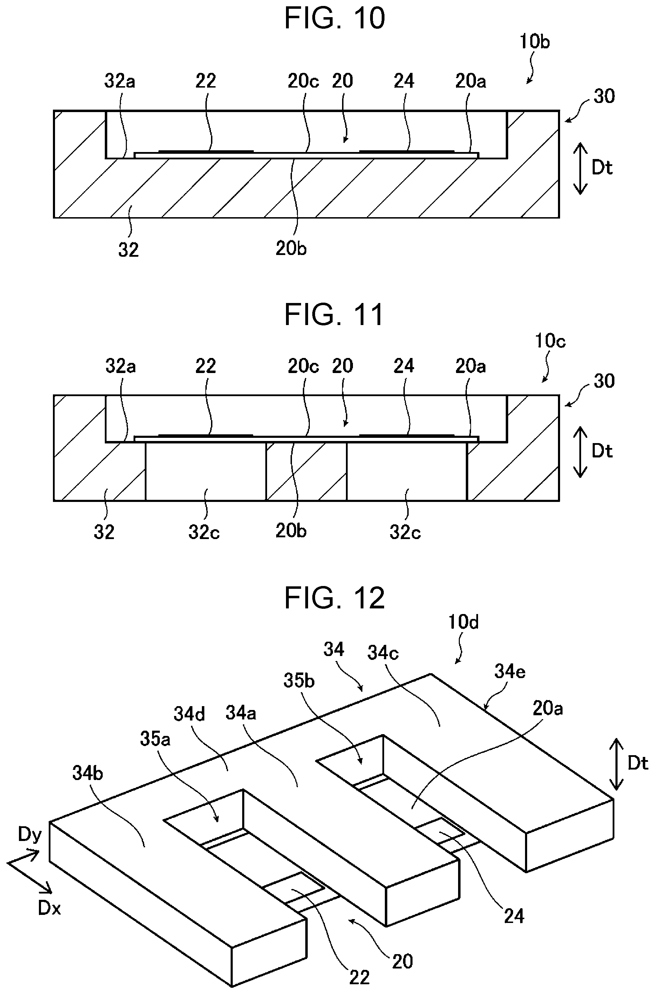

Fig. 8 is a schematic perspective view showing a third example of the structure according to the embodiment of the invention. Fig. 9 is a schematic plan view showing the third example of the structure according to the embodiment of the invention. Fig. 10 is a schematic cross-sectional view showing the third example of the structure according to the embodiment of the invention. In Figs. 8 to 10, the same components as those in Figs. 1 to 3 are denoted by the same reference numerals, and their detailed description will be omitted.

The structure 10b shown in Fig. 8 differs from the structure 10 shown in Figs. 1 to 3 in the configuration of the magnetic material portions, and the other configurations are the same as those of the structure 10 shown in Figs. 1 to 3. With the configuration of the structure 10b, the same effects as those of the structure 10 shown in Fig. 1 can be obtained.

The structure 10b has the substrate 20 and the transmitting antenna element 22 and the receiving antenna element 24 disposed on the front surface 20a of the substrate 20.

As shown in Figs. 8 to 10, the structure 10b has a magnetic material wall portion 30 disposed on the front surface 20a of the substrate 20 except for a region 20c between the transmitting antenna element 22 and the receiving antenna element 24 so as to surround the transmitting antenna element 22 and the receiving antenna element 24. The structure 10b further has a magnetic material portion 32 disposed so as to cover the entire back surface 20b of the substrate 20.

The substrate 20 has a quadrilateral outer shape. The magnetic material wall portion 30 is disposed along the outer circumference of the substrate 20 and is not disposed in the region 20c between the transmitting antenna element 22 and the receiving antenna element 24. When the substrate 20 is viewed in a direction normal to the front surface 20a, the magnetic material wall portion 30 is arranged in a quadrilateral frame shape.

In Fig. 8, the magnetic material portion 32 is disposed over the entire back surface 20b of the substrate 20.

For example, the magnetic material wall portion 30 and the magnetic material portion 32 are formed integrally. The magnetic material wall portion 30 is disposed on an outer peripheral portion of the front surface 32a of the magnetic material portion 32, and a concave section is thereby formed with the front surface 32a of the magnetic material portion 32 serving as its bottom surface. The substrate 20 is disposed such that its back surface 20b faces the bottom surface of the concave section.

In the structure 10b, the magnetic material portion 32 is disposed over the entire back surface 20b of the substrate 20, but this is not a limitation. For example, the magnetic material portion 32 may have blank regions 32c that correspond to the formation region of the transmitting antenna element 22 and the formation region of the receiving antenna element 24, as in a structure 10c shown in Fig. 11. With the configuration of the structure 10c also, the same effects as those of the structure 10 shown in Fig. 1 can be obtained.

The configuration of the magnetic material wall portion 30 and the configuration of the magnetic material portion 32 are the same as the configuration of the magnetic material portions 26 described above.

By providing the magnetic material wall portion 30 on the outer edge portions of the front surface 32a of the magnetic material portion 32, the concave section is formed with the front surface 32a of the magnetic material portion 32 serving as the bottom surface. For example, the magnetic material portion 32 is formed using a pattern printing method, and then the magnetic material wall portion 30 having a quadrilateral frame shape is formed on the outer edge portions of the magnetic material portion 32 using the pattern printing method.

The substrate 20 having the transmitting antenna element 22 and the receiving antenna element 24 formed on the front surface 20a is prepared. In this case, the substrate 20 has no magnetic material portions formed therein.

Then the substrate 20 is disposed such that the back surface 20b of the substrate 20 faces the bottom surface of the concave section, i.e., the front surface 32a of the magnetic material portion 32. The substrate 20 is bonded and fixed to the front surface 32a of the magnetic material portion 32 using, for example, a thermosetting or photocurable adhesive. The structure 10b can be obtained in the manner described above. The structure 10c can be produced using the same procedure as that for the structure 10c except that the magnetic material portion 32 has a different configuration.

### Fourth example of structure

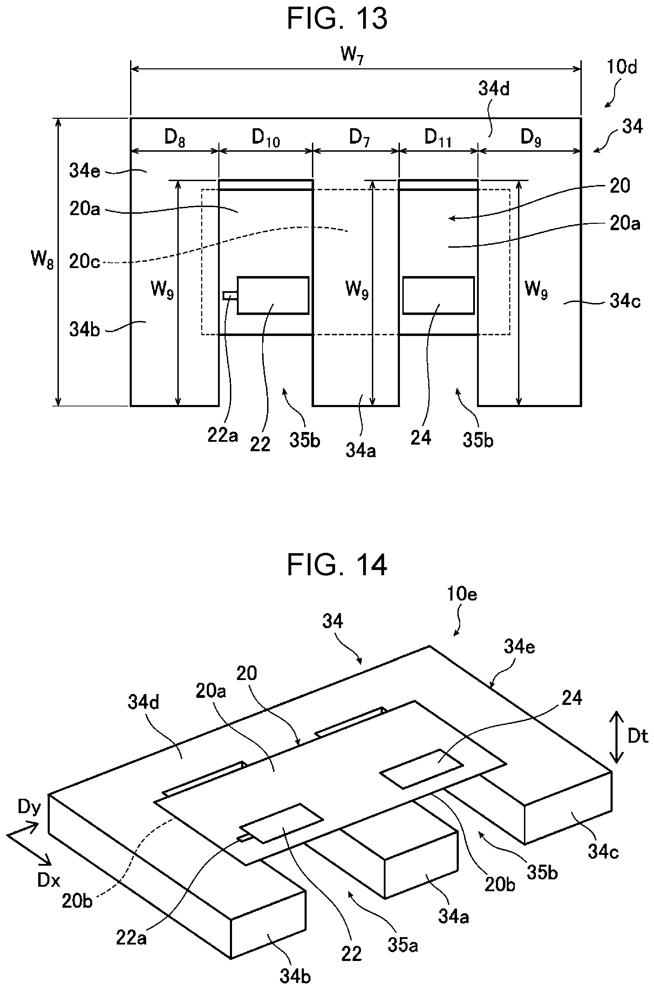

Fig. 12 is a schematic perspective view showing a fourth example of the structure according to the embodiment of the invention. Fig. 13 is a schematic plan view showing the fourth example of the structure according to the embodiment of the invention. Fig. 14 is a schematic perspective view showing a modification of the fourth example of the structure according to the embodiment of the invention. In Figs. 12 to 14, the same components as those in Figs. 1 to 3 are denoted by the same reference numerals, and their detailed description will be omitted.

The structure 10d shown in Fig. 12 differs from the structure 10 shown in Figs. 1 to 3 in the configuration of the magnetic material portions, and the other configurations are the same as those of the structure 10 shown in Figs. 1 to 3. With the configuration of the structure 10a also, the same effects as those of the structure 10 shown in Fig. 1 can be obtained.

The structure 10d has the substrate 20, the transmitting antenna element 22 and the receiving antenna element 24 disposed on the front surface 20a of the substrate 20, and a magnetic material layer 34 disposed on the substrate 20.

When the substrate 20 is viewed in a direction normal to the front surface 20a, the magnetic material layer 34 has: a first magnetic material portion 34a disposed between the transmitting antenna element 22 and the receiving antenna element 24; a second magnetic material portion 34b disposed so as to sandwich the transmitting antenna element 22 together with the first magnetic material portion 34a; a third magnetic material portion 34c disposed so as to sandwich the receiving antenna element 24 together with the first magnetic material portion 34a; and a fourth magnetic material portion 34d connecting the first magnetic material portion 34a, the second magnetic material portion 34b, and the third magnetic material portion 34c.

The fourth magnetic material portion 34d is disposed so as to avoid the region in which the transmitting antenna element 22 is disposed and the region in which the receiving antenna element 24 is disposed. The fourth magnetic material portion 34d connects the first magnetic material portion 34a, the second magnetic material portion 34b, and the third magnetic material portion 34c in regions other than the regions in which the transmitting antenna element 22 and the receiving antenna element 24 are disposed.

More specifically, as shown in Figs. 12 and 13, the first magnetic material portion 34a, the second magnetic material portion 34b, and the third magnetic material portion 34c of the magnetic material layer 34 are linear members extending in a one direction Dx. The fourth magnetic material portion 34d is a linear member extending in a another direction Dy orthogonal to the one direction Dx. The first magnetic material portion 34a, the second magnetic material portion 34b, and the third magnetic material portion 34c are spaced apart from each other and are disposed parallel to each other. A gap 35a is present between the first magnetic material portion 34a and the second magnetic material portion 34b. A gap 35b is present between the first magnetic material portion 34a and the third magnetic material portion 34c.

The fourth magnetic material portion 34d connects the first magnetic material portion 34a, the second magnetic material portion 34b, and the third magnetic material portion 34c at their end portions 34e with respect to the one direction Dx.

The first magnetic material portion 34a, the second magnetic material portion 34b, the third magnetic material portion 34c, and the fourth magnetic material portion 34d that form the magnetic material layer 34 have the same thickness in the thickness direction Dt.

The thickness direction Dt, the one direction Dx, and the another direction Dy are orthogonal to each other.

As shown in Figs. 12 and 13, the transmitting antenna element 22 is disposed in the gap 35a between the first magnetic material portion 34a and the second magnetic material portion 34b of the magnetic material layer 34, and the gap 35a provides an open space above the transmitting antenna element 22. The receiving antenna element 24 is disposed in the gap 35b between the first magnetic material portion 34a and the third magnetic material portion 34c, and the gap 35b provides an open space above the receiving antenna element 24.

In the structure 10d, the transmitting antenna element 22, the receiving antenna element 24, and the magnetic material layer 34 are disposed on the front surface 20a of the substrate 20.

The arrangement of the magnetic material layer 34 is not limited to that shown in Fig. 12. For example, the transmitting antenna element 22 and the receiving antenna element 24 may be disposed on the front surface 20a of the substrate, and the magnetic material layer 34 may be disposed on the back surface 20b side of the substrate 20, as in a structure 10e shown in Fig. 14. In the structure 10e, the magnetic material layer 34 is disposed on the back surface 20b side of the substrate 20, and nothing is provided on the front surface 20a side of the substrate. The gap 35a between the first magnetic material portion 34a and the second magnetic material portion 34b is present on the back surface 20b side of the substrate 20 and is located in a region corresponding to the formation region of the transmitting antenna element 22. The gap 35b between the first magnetic material portion 34a and the third magnetic material portion 34c is located in a region corresponding to the formation region of the receiving antenna element 24.

Preferably, the magnetic material layer 34 is disposed on the back surface 20b side of the substrate 20, as in the structure 10e, rather than in the structure 10d. This is because the far-field gain is high and the transmitting antenna element has a higher antenna gain.

To produce the structure 10d shown in Fig. 12, the substrate 20 having the transmitting antenna element 22 and the receiving antenna element 24 formed on the front surface 20a is first prepared. In this case, no magnetic material portions are formed in the substrate 20. Next, the magnetic material layer 34 shown in Fig. 12 is formed on the front surface 20a of the substrate 20 by a spraying method using a mask or a screen printing method. The structure 10d can thereby be obtained. The structure 10e can be produced using the same procedure as that for the structure 10d except that the magnetic material layer 34 is formed on the back surface 20b of the substrate 20.

### Other configurations

Examples of the semiconductor element are as follows.

No particular limitation is imposed on the semiconductor element, and examples thereof include logic large scale integrated circuits (LSIs), application specific integrated circuits (ASICs), field programmable gate arrays (FPGAs), application specific standard products (ASSPs), microprocessors (such as central processing units (CPUs) and graphics processing units (GPUs)), memories (such as dynamic random access memories (DRAMs), hybrid memory cubes (HMCs)), magnetic RAM (MRAMs: magnetic memories), phase-change memories (PCMs), resistive RAMs (ReRAMs), ferroelectric RAMs (FeRAMs), flash memories (Not AND (NAND) flash memories), power devices, analog integrated circuits (ICs), direct current (DC)-direct current (DC) convertors, insulated gate bipolar transistors (IGBTs), A/D convertors, micro electro mechanical systems (MEMSs) such as acceleration sensors, pressure sensors, oscillators, and gyro sensors, power amplifiers, wireless devices (such as global positioning systems (GPSs) and frequency modulation (FM) devices), nearfield communication (NFC) devices, RF expansion modules (RFEMs), monolithic microwave integrated circuits (MMICs), wireless local area networks (WLANs )), discrete elements, back side illuminations (BSIs), contact image sensors (CISs), camera modules, complementary metal oxide semiconductors (CMOSs), passive devices, band pass filters, surface acoustic wave (SAW) filters, radio frequency (RF) filters, radio frequency integrated passive devices (RFIPDs), and broad band (BB) devices.

For example, the array antenna has a plurality of antennas. For example, the plurality of antennas are of the same type. No particular limitation is imposed on the configuration of the antennas included in the array antenna, and the antennas are appropriately selected according to the transmission or reception frequency range, the direction of polarized waves to be received, etc. No particular limitation is imposed on the number of antennas in the array antenna. The number of antennas is appropriately determined according to the space available, the intended application, etc.

Various components contained in the composition containing the magnetic material particles will next be described in detail.

### Magnetic material particles

One type of magnetic material particles may be used, or a plurality of types of magnetic material particles may be used. The magnetic material particles contain metal atoms.

In the present specification, the term "metal atoms" is intended to also encompass semimetal atoms such as boron, silicon, germanium, arsenic, antimony, and tellurium atoms.

The metal atoms may be contained in the magnetic material particles as an alloy containing a metal element (preferably a magnetic alloy), a metal oxide (preferably a magnetic oxide), a metal nitride (preferably a magnetic oxide), or a metal carbide (preferably a magnetic carbide).

The content of the metal atoms is preferably 50 to 100% by mass, more preferably 75 to 100% by mass, and still more preferably 95 to 100% by mass with respect to the total mass of the magnetic material particles.

No particular limitation is imposed on the metal atoms, and it is preferable that the magnetic material particles contain at least one type of metal atoms selected from the group consisting of Fe, Ni, and Co.

The content of the at least one type of metal atoms selected from the group consisting of Fe, Ni, and Co (the total content in a case where a plurality of types are contained) is preferably 50% by mass or more, more preferably 60% by mass or more, and still more preferably 70% by mass or more with respect to the total mass of metal atoms in the magnetic material particles. No particular limitation is imposed on the upper limit of the content, and the content is, for example, 100% by mass or less, preferably 98% by mass or less, and more preferably 95% by mass or less.

The magnetic material particles may contain a material other than Fe, Ni, and Co, and specific examples of the material include Al, Si, S, Sc, Ti, V, Cu, Y, Mo, Rh, Pd, Ag, Sn, Sb, Te, Ba, Ta, W, Re, Au, Bi, La, Ce, Pr, Nd, P, Zn, Zr, Mn, Cr, Nb, Pb, Ca, B, C, N, and O.

In a case where the magnetic material particles contain metal atoms other than Fe, Ni, and Co, it is preferable that the magnetic material particles contain at least one type of metal atoms selected from the group consisting of Si, Cr, B, and Mo.

Examples of the magnetic material particles include: particles of alloys such as Fe-Co-based alloys (preferably permendur), Fe-Ni-based alloys (such as permalloy), Fe-Zr-based alloys, Fe-Mn-based alloys, Fe-Si-based alloys, Fe-Al-based alloys, Ni-Mo-based alloys (preferably supermalloy), Fe-Ni-Co-based alloys, Fe-Si-Cr-based alloys, Fe-Si-B-based alloys, Fe-Si-Al-based alloys (preferably sendust), Fe-Si-B-C-based alloys, Fe-Si-B-Cr-based alloys, Fe-Si-B-Cr-C-based alloys, Fe-Co-Si-B-based alloys, Fe-Si-B-Nb-based alloys, Fe nanocrystalline alloys, Fe-based amorphous alloys, and Co-based amorphous alloys; and particles of ferrites such as spinel ferrites (preferably Ni-Zn-based ferrite and Mn-Zn-based ferrite) and hexagonal ferrites (preferably barium ferrite and magnetoplumbite hexagonal ferrite). These alloys may be amorphous.

In terms of radio wave absorption performance, the hexagonal ferrite is preferably a substituted magnetoplumbite hexagonal ferrite in which part of iron atoms in the hexagonal ferrite are substituted with aluminum atoms. A Ba-Fe-Al-based alloy, a Ca-Fe-Al-based alloy, or a Pb-Fe-Al-based alloy in which part of the alloy is substituted with Ba, Ca, or Pb is more preferred in terms of absorption of radio waves in a high-frequency band.

One type of magnetic material particles may be used alone, or a combination of two or more types may be used.

A surface layer may be disposed on the surfaces of the magnetic material particles. The surface layer on the magnetic material particles can impart, to the magnetic material particles, a function determined by the material of the surface layer.

The surface layer is an inorganic layer or an organic layer.

No particular limitation is imposed on the thickness of the surface layer. The thickness is preferably 3 to 1000 nm because the function of the surface layer is more effectively exerted.

The number average particle diameter of the magnetic material particles is preferably 20 nm to 50 µm. From the viewpoint of dispersibility into the composition and the pattern resolution, the number average particle diameter of the magnetic material particles is more preferably 20 to 1000 nm and still more preferably 20 to 500 nm.

The number average particle diameter of the magnetic material particles is measured as follows. A photograph of the magnetic material particles is captured using a transmission electron microscope at a capturing magnification of 100,000x and printed on photographic paper such that the total magnification is 500,000x. Then a digitizer is used to trace the contours of the particles (primary particles), and the diameters of circles having the same areas as the traced regions (equivalent circle diameters) are computed. The primary particles are independent particles with no aggregation. The image is captured using the transmission electron microscope by a direct method at an acceleration voltage of 300 kV. The transmission electron microscope observation and measurement can be performed using a transmission electron microscope H-9000 manufactured by Hitachi, Ltd. and image analysis software KS-400 manufactured by Carl Zeiss. The diameters of at least 100 primary magnetic material particles measured as described above are arithmetically averaged to compute the number average particle diameter.

The particle diameters of the magnetic material particles may be their volume average particle diameters. No particular limitation is imposed on the volume average particle diameter. The volume average particle diameter is often 1 to 60 µm and is preferably 5 to 55 µm and more preferably 10 to 50 µm because the effects of the invention are further enhanced. The volume average particle diameter of the magnetic material particles is a so-called median diameter (D50) and can be determined using a particle size distribution curve, which is a volume-based frequency distribution of the magnetic material particles obtained using a laser diffraction/scattering particle diameter distribution measurement device (such as "LA960N" manufactured by HORIBA Ltd.).

No particular limitation is imposed on the shape of the magnetic material particles, and the magnetic material particles may have a plate shape, an elliptical shape, or a spherical shape or may have no regular shape.

The content of the magnetic material particles with respect to the total mass of the composition is preferably 20 to 99% by mass, more preferably 25 to 80% by mass, and still more preferably 30 to 70% by mass.

The content of the magnetic material particles with respect to the total mass of solids in the composition is preferably 30 to 99% by mass, more preferably 30 to 80% by mass, and still more preferably 40 to 70% by mass.

The total mass of solids in the composition means the mass of the components forming magnetic material portions excluding the solvent in the composition. Any component included in the magnetic material portions is regarded as a solid even when the component is in a liquid form.

### Polymerizable compound

The photosensitive composition may contain a polymerizable compound.

The polymerizable compound is a compound having a polymerizable group (a thermally polymerizable compound or a photo-polymerizable compound), and examples thereof include a compound containing a group including an ethylenically unsaturated bond (which may be hereinafter referred to simply as an "ethylenically unsaturated group") and a compound having an epoxy group and/or an oxetanyl group.

Preferably, the composition contains a compound having an epoxy group and/or an oxetanyl group as a polymerizable compound. In particular, the compound is preferably a polyfunctional epoxy compound (a compound having a plurality of epoxy groups).

The polymerizable compound preferably includes at least one group selected from the group consisting of epoxy groups and oxetanyl groups and more preferably includes at least two such groups. The upper limit of the number of these groups is, for example, 15 or less.

Examples of the polyfunctional epoxy compound include bisphenol A type epoxy resins, bisphenol F type epoxy resins, phenol novolac type epoxy resins, cresol novolac type epoxy resins, alicyclic epoxy resins, and aliphatic polyglycidyl ethers.

Specific examples of the polyfunctional epoxy compound include: EPOLEAD (registered trademark) GT401, EPOLEAD PB 3600, EPOLEAD PB4700, CELLOXIDE (registered trademark) 2021, CELLOXIDE 3000, and EHPE 3150 (manufactured by Daicel Corporation); jER1001, jER1002, jER1003, jER1004, jER1007, jER1009, jER1010, jER828, jER871, jER872, jER180S75, jER807, jER890, jER152, and jER154 (manufactured by Mitsubishi Chemical Corporation); EPPN201, EPPN202, EOCN-102, EOCN-103S, EOCN-104S, EOCN-1020, EOCN-1025, and EOCN-1027 (manufactured by Nippon Kayaku Co., Ltd.); EPICLON (registered trademark) 200 and EPICLON 400 (manufactured by DIC Corporation); DENACOL (registered trademark) EX-611, DENACOL EX-612, DENACOL EX-614, DENACOL EX-622, DENACOL EX-411, DENACOL EX-512, DENACOL EX-522, DENACOL EX-421, DENACOL EX-313, DENACOL EX-314, and DENACOL EX-321 (manufactured by Nagase ChemteX Corporation); and TEPIC-S (manufactured by Nissan Chemical Industries, Ltd.).

No particular limitation is imposed on the content of the polymerizable compound in the composition. The content of the polymerizable compound is preferably 1 to 40% by mass and more preferably 5 to 30% by mass with respect to the total mass of solids in the composition.

The composition may contain additional materials other than the magnetic material particles and the polymerizable compound.

### Resin

The composition may contain a resin.

Examples of the resin include (meth)acrylic resins, epoxy resins, ene-thiol resins, polycarbonate resins, polyether resins, polyarylate resins, polysulfone resins, polyether sulfone resins, polyphenylene resins, polyarylene ether phosphine oxide resins, polyimide resins, polyamide-imide resins, polyolefin resins, cyclic olefin resins, polyester resins, styrene resins, and phenoxy resins.

One of these resins may be used alone, or a mixture of two or more may be used.

One preferred mode of the resin is a resin having an unsaturated double bond (such as an ethylenically unsaturated double bond) and a polymerizable group such as an epoxy group or an oxetanyl group.

Another preferred mode of the resin is a resin having an acid group, a basic group, or an amide group. The resin having an acid group, a basic group, or an amide group tends to function as a dispersing agent for dispersing the magnetic material particles.

Examples of the acid group include a carboxy group, a phosphoric acid group, a sulfo group, and a phenolic hydroxy group, and a carboxy group is preferred.

Examples of the basic group include amino groups (groups obtained by removing one hydrogen atom from ammonia, primary amines, and secondary amines) and an imino group.

In particular, it is preferable that the resin has a carboxy group or an amide group.

In a case where the resin has an acid group, the acid value of the resin is preferably 10 to 500 mg KOH/g and more preferably 30 to 400 mg KOH/g.

To improve the dispersibility of the resin in the composition, the resin used is preferably a resin having a solubility in a solvent of 10 g/L or more and more preferably a resin having a solubility in a solvent of 20 g/L or more.

The upper limit of the solubility of the resin in a solvent is preferably 2000 g/L or less and more preferably 1000 g/L or less.

The solubility of the resin in a solvent means the amount (g) of the resin dissolved in 1 L of the solvent at 25°C.

The content of the resin is preferably 0.1 to 30% by mass and more preferably 0.2 to 10% by mass with respect to the total mass of the composition.

One preferred mode of the resin is a resin serving as a dispersing agent that can disperse the magnetic material particles in the composition (this resin is hereinafter referred to also as a "dispersing resin"). By using the dispersing resin, the effects of the invention are further enhanced.

### Resin having repeating unit including graft chain

Examples of the dispersing resin include a resin having a repeating unit including a graft chain (this resin may be hereinafter referred to as a "resin A"). However, the resin A can be used for the purpose other than providing the function of a dispersing agent.

In a case where the composition contains the resin A, the content of the resin A is preferably 0.1 to 30% by mass and more preferably 0.2 to 20% by mass with respect to the total mass of the composition because the effects of the invention are further enhanced.

### Repeating unit including graft chain

In the repeating unit including a graft chain, the graft chain may be long. In this case, the steric repulsion effect is enhanced, and the dispersibility of the magnetic material particles is improved. However, if the graft chain is excessively long, the adsorptive power onto the magnetic material particles decreases, and the dispersibility of the magnetic material particles tends to decrease. Therefore, the number of atoms in the graft chain excluding hydrogen atoms is preferably 40 to 10000. The number of atoms excluding hydrogen atoms is more preferably 50 to 2000 and still more preferably 60 to 500.

The graft chain is a group extending from its base, at which the group branches off from the main chain (which is an atom that is included in the group branching off from the main chain and that is bonded to the main chain), to its terminal.

Preferably, the graft chain includes a polymer structure. Examples of the polymer structure include a poly(meth)acrylate structure (such as a poly(meth)acrylic structure), a polyester structure, a polyurethane structure, a polyurea structure, a polyamide structure, and a polyether structure.

To improve the interactability between the graft chain and the solvent to thereby increase the dispersibility of the magnetic material particles, it is preferable that the graft chain includes at least one selected from the group consisting of a polyester structure, a polyether structure, and a poly(meth)acrylate structure, and it is more preferable that the graft chain includes at least one of a polyester structure or a polyether structure.

The resin A may be a resin obtained using a graft chain-containing macromonomer (a monomer having a polymer structure and to be bonded to the main chain to form the graft chain).

No particular limitation is imposed on the graft chain-containing macromonomer (the monomer having a polymer structure and to be bonded to the main chain to form the graft chain). The macromonomer used is preferably a macromonomer including a reactive double bond group.

The resin A preferably includes at least one structure selected from the group consisting of polymethyl acrylate, polymethyl methacrylate, and cyclic or chain polyester, more preferably includes at least one structure selected from the group consisting of polymethyl acrylate, polymethyl methacrylate, and linear polyester, and still more preferably includes at least one structure selected from the group consisting of a polymethyl acrylate structure, a polymethyl methacrylate structure, a polycaprolactone structure, and a polyvalerolactone structure. The resin A may include only one of the structures described above or may include a plurality of structures selected from the above structures.

The polycaprolactone structure is a structure including, as a repeating unit, a structure formed as a result of ring opening of ε-caprolactone. The polyvalerolactone structure is a structure including, as a repeating unit, a structure formed as a result of ring opening of δ-valerolactone.

In the resin A, the mass content of the repeating unit including a graft chain is preferably 2 to 100% by mass, more preferably 2 to 90% by mass, and still more preferably 5 to 30% by mass with respect to the total mass of the resin A. In a case where the content of the repeating unit including a graft chain is within the above range, the effects of the invention are further enhanced.

### Hydrophobic repeating unit

The resin A may include a hydrophobic repeating unit different from the repeating unit including a graft chain (i.e., a repeating unit that does not correspond to the repeating unit including a graft chain). In the present specification, the hydrophobic repeating unit is a repeating unit having no acid groups (such as a carboxylic acid group, a sulfonic acid group, a phosphoric acid group, and a phenolic hydroxy group).

The hydrophobic repeating unit is preferably a repeating unit derived from (corresponding to) a compound (monomer) having a Clog P value of 1.2 or more and more preferably a repeating unit derived from a compound having a Clog P value of 1.2 to 8. In this case, the effects of the invention can be more reliably obtained.

The Clog P value is a value computed, for example, using a program "CLOGP" available from Daylight Chemical Information System, Inc. This program provides a "computational log P" value computed using the Hansch-Leo fragment approach (see documents below). The fragment approach is based on the chemical structure of a compound. Specifically, the chemical structure is divided into partial structures (fragments), and then the degrees of contribution to log P that are assigned to the fragments are summed up to thereby estimate the log P value of the compound. The details are described in the following documents. In the present specification, the Clog P value computed using program CLOGP v4.82 is used.

A. J. Leo, Comprehensive Medicinal Chemistry, Vol. 4, C. Hansch, P. G. Sammnens, J. B. Taylor and C. A. Ramsden, Eds., p. 295, Pergamon Press, 1990; C. Hansch & A. J. Leo. Substituent Constants For Correlation Analysis in Chemistry and Biology. John Wiley & Sons.; A. J. Leo. Calculating log Poct from structure, Chem. Rev., 93, 1281-1306, 1993.

Log P means a common logarithm of a partition coefficient P, is a quantitative physical value indicating how an organic compound is partitioned in an oil (generally 1-octanol) / water binary system in equilibrium, and is represented by the following formula.$Log P = log \left(Coil / Cwater\right)$

Here, Coil is the molar concentration of the compound in the oil phase, and Cwater is the molar concentration of the compound in the water phase.

As the value of log P crosses zero and increases in the positive direction, the oil solubility increases. As the absolute value of log P increases in the negative direction, the water solubility increases. Log P has a negative correlation with the water solubility of the organic compound and is widely used as a parameter for estimating the hydrophilicity and hydrophobicity of the organic compound.

The mass content of the hydrophobic repeating unit in the resin A is preferably 5 to 90% by mass and more preferably 20 to 80% by mass with respect to the total mass of the resin A.

### Functional group capable of interacting with magnetic material particles

The resin A may have a functional group capable of interacting with the magnetic material particles.

Preferably, the resin A further includes a repeating unit including a functional group capable of interacting with the magnetic material particles.

Examples of the functional group capable of interacting with the magnetic material particles include acid groups, basic groups, coordinating groups, and reactive functional groups.

In a case where the resin A includes an acid group, a basic group, a coordinating group, or a reactive functional group, it is preferable that the resin A includes a repeating unit including the acid group, a repeating unit including the basic group, a repeating unit including the coordinating group, or a repeating unit including the reactive functional group.

A repeating unit including an alkali-soluble group serving as an acid group may be the same as or different from the above-described repeating unit including a graft chain. However, the repeating unit including an alkali-soluble group serving as an acid group is a repeating unit different from the hydrophobic repeating unit described above (i.e., does not correspond to the hydrophobic repeating unit).

Examples of the acid group serving as the functional group capable of interacting with the magnetic material particles include carboxylic acid groups, sulfonic acid groups, phosphoric acid groups, and phenolic hydroxy groups. The acid group is preferably at least one selected from the group consisting of carboxylic acid groups, sulfonic acid groups, and phosphoric acid groups and more preferably a carboxylic acid group. The carboxylic acid group has high adsorptive power onto the magnetic material particles and is highly dispersible.

Specifically, it is preferable that the resin A further includes a repeating unit including at least one selected from the group consisting of carboxylic acid groups, sulfonic acid groups, and phosphoric acid groups.

The resin A may have one or two or more types of repeating units including the acid group.

In a case where the resin A includes the repeating unit including the acid group, the mass content of the repeating unit is preferably 5 to 80% by mass and more preferably 10 to 60% by mass with respect to the total mass of the resin A.

Examples of the basic group serving as the functional group capable of interacting with the magnetic material particles include primary amino groups, secondary amino groups, tertiary amino groups, heterocycles including a N atom, and amide groups. The basic group is preferably a tertiary amino group because of its high adsorptive power onto the magnetic material particles and high dispersibility. The resin A may contain one or two or more basic groups.

In a case where the resin A includes the repeating unit including the basic group, the mass content of the repeating unit is preferably 0.01 to 50% by mass and more preferably 0.01 to 30% by mass with respect to the total mass of the resin A.

Examples of the coordinating group and the reactive functional group each serving as the functional group capable of interacting with the magnetic material particles include an acetylacetoxy group, trialkoxysilyl groups, isocyanate groups, acid anhydrides, and acid chlorides. The functional group is preferably an acetylacetoxy group because its adsorptive power onto the magnetic material particles is high and it increases the dispersibility of the magnetic material particles. The resin A may have one or two or more of these groups.

In a case where the resin A includes the repeating unit including the coordinating group or the repeating unit including the reactive functional group, the mass content of the repeating unit is preferably 10 to 80% by mass and more preferably 20 to 60% by mass with respect to the total mass of the resin A.

### Ethylenically unsaturated group

The resin A may include an ethylenically unsaturated group.

No particular limitation is imposed on the ethylenically unsaturated group. Examples of the ethylenically unsaturated group include a (meth)acryloyl group, a vinyl group, and a styryl group, and a (meth)acryloyl group is preferred.

In particular, the resin A preferably includes a repeating unit including an ethylenically unsaturated group on a side chain and more preferably includes a repeating unit derived from a (meth)acrylate and including an ethylenically unsaturated group on a side chain (this repeating unit may be hereinafter referred to also as a (meth)acrylic-based repeating unit including an ethylenically unsaturated group on a side chain).

The acrylic-based repeating unit including an ethylenically unsaturated group on a side chain is obtained, for example, using a resin A including a carboxylic acid group-containing (meth)acrylic-based repeating unit. Specifically, an ethylenically unsaturated compound including a glycidyl group or an alicyclic epoxy group is added by an addition reaction to the carboxylic acid group included in the (meth)acrylic-based repeating unit. The (meth)acrylic-based repeating unit including an ethylenically unsaturated group on a side chain can be obtained by allowing the thus-introduced ethylenically unsaturated group (glycidyl or alicyclic epoxy group) to react.

In a case where the resin A includes the repeating unit including an ethylenically unsaturated group, its mass content is preferably 10 to 80% by mass and more preferably 15 to 40% by mass with respect to the total mass of the resin A.

### Additional repeating units

To improve various performance capabilities such as the film forming capability of the resin A, the resin A may further include additional repeating units having various functions that differ from the functions of the repeating unit including a graft chain, the hydrophobic repeating unit, and the repeating unit including a functional group capable of interacting with the magnetic material particles, so long as the effects of the invention are not impaired.

Examples of the additional repeating units include repeating units derived from radically polymerizable compounds selected from the group consisting of acrylonitriles and methacrylonitriles.

One or two or more types of additional repeating units may be used for the resin A, and the mass content thereof is preferably 0 to 80% by mass and more preferably 10 to 60% by mass with respect to the total mass of the resin A.

### Physical properties of resin A

No particular limitation is imposed on the acid value of the resin A. However, the acid value is, for example, preferably 0 to 400 mg KOH/g, more preferably 10 to 350 mg KOH/g, still more preferably 30 to 300 mg KOH/g, and particularly preferably 50 to 200 mg KOH/g.

In a case where the acid value of the resin A is 50 mg KOH/g or more, the settling stability of the magnetic material particles can be further improved.

In the present specification, the acid value of a compound can be computed, for example, from the average content of the acid group in the compound. By adjusting the content of the acid group-containing repeating unit in the resin, the resulting resin has the desired acid value.

No particular limitation is imposed on the weight average molecular weight of the resin A. The weight average molecular weight of the resin A is, for example, preferably 3,000 or more, more preferably 4,000 or more, still more preferably 5,000 or more, and particularly preferably 6,000 or more. The upper limit of the weight average molecular weight is, for example, preferably 300,000 or less, more preferably 200,000 or less, still more preferably 100,000 or less, and particularly preferably 50,000 or less.

The resin A can be synthesized using a well-known method.

### Alkali-soluble resin

The resin may contain an alkali-soluble resin. In the present specification, the alkali-soluble resin means a resin including a group that increases alkali-solubility (an alkali-soluble group, e.g., an acid group such as a carboxylic acid group) and means a resin different from the resin A described above.

The alkali-soluble resin is a resin including at least one alkali-soluble group per molecule, and examples thereof include polyhydroxystyrene resins, polysiloxane resins, (meth)acrylic resins, (meth)acrylamide resins, (meth)acrylic/(meth)acrylamide copolymers, epoxy resins, and polyimide resins.

Specific examples of the alkali-soluble resin include copolymers of an unsaturated carboxylic acid and an ethylenically unsaturated compound.

No particular limitation is imposed on the unsaturated carboxylic acid. Examples of the unsaturated carboxylic acid include: monocarboxylic acids such as (meth)acrylic acid, crotonic acid, and vinylacetic acid; dicarboxylic acids such as itaconic acid, maleic acid, and fumaric acid and acid anhydrides thereof; and polycarboxylic acid monoesters such as mono(2-(meth)acryloyloxyethyl) phthalate.

Examples of a copolymerizable ethylenically unsaturated compound include methyl (meth)acrylate. Compounds described in paragraph 0027 of JP2010-097210A and paragraphs 0036 to 0037 of JP2015-068893A can also be used, and the contents of which are incorporated in the present specification.

The alkali-soluble resin used may be combined with a copolymerizable ethylenically unsaturated compound having an ethylenically unsaturated group on a side chain. Specifically, the alkali-soluble resin may include a repeating unit including an ethylenically unsaturated group on a side chain.

The ethylenically unsaturated group included in a side chain is preferably a (meth)acrylic acid group.

The repeating unit including an ethylenically unsaturated group on a side chain can be obtained, for example, by adding, by an addition reaction, an ethylenically unsaturated compound including a glycidyl or alicyclic epoxy group to a carboxylic acid group in a carboxylic acid group-containing (meth)acrylic-based repeating unit.

The alkali-soluble resin is also preferably an alkali-soluble resin including a curable group.

Examples of the curable group include, but are not limited to, ethylenically unsaturated groups (such as a (meth)acryloyl group, a vinyl group, and a styryl group) and cyclic ether groups (such as an epoxy group and an oxetanyl group).

In particular, the curable group is preferably an ethylenically unsaturated group and more preferably a (meth)acryloyl group because polymerization can be controlled through a radical reaction.

Preferably, the alkali-soluble resin including the curable group is, for example, an alkali-soluble resin having the curable group on a side chain. Examples of the alkali-soluble resin including the curable group include: the DIANAL (registered trademark) NR series (manufactured by Mitsubishi Chemical Corporation); Photomer 6173 (COOH-containing polyurethane acrylic oligomer manufactured by Diamond Shamrock Co., Ltd.); Viscoat R-264 and KS resist 106 (manufactured by OSAKA ORGANIC CHEMICAL INDUSTRY LTD.); the CYCLOMER P series (such as ACA230AA) and the PLACCEL CF200 series (manufactured by Daicel Corporation); Ebecryl 3800 (manufactured by DAICEL-ALLNEX LTD.); and ACRYCURE RD-F8 (manufactured by NIPPON SHOKUBAI Co., Ltd.).

The alkali-soluble resin used may be a polyimide precursor. The polyimide precursor means a resin obtained by an addition polymerization reaction of a compound including an acid anhydride group and a diamine compound at 40 to 100°C.

No particular limitation is imposed on the acid value of the alkali-soluble resin. The acid value of the alkali-soluble resin is preferably 30 to 500 mg KOH/g and more preferably 50 to 200 mg KOH/g or more.

In a case where the composition contains the alkali-soluble resin, the content of the alkali-soluble resin is preferably 0.1 to 40% by mass and more preferably 0.5 to 30% by mass with respect to the total mass of the composition.

### Solvent

The composition may contain a solvent. Examples of the solvent include water and organic solvents, and an organic solvent is preferred.

From the viewpoint of ease of application, the boiling point of the solvent is preferably 100 to 400°C, more preferably 150 to 300°C, and still more preferably 170 to 250°C. In the present specification, the boiling point means the normal boiling point, unless otherwise specified.

The content of the solvent is preferably 1 to 60% by mass, more preferably 2 to 50% by mass, and still more preferably 3 to 40% by mass with respect to the total mass of the composition because the effects of the invention are further enhanced.

### Curing agent

The composition may contain a curing agent.

No particular limitation is imposed on the curing agent, and a well-known curing agent may be used.

No particular limitation is imposed on the content of the curing agent in the composition. The content of the curing agent is preferably 0.5 to 15% by mass and more preferably 1.0 to 10% by mass with respect to the total mass of solids in the composition.

### Additional optional components

The composition may further include additional optional components other than the components described above. Examples thereof include a surfactant, a thixotropic agent, a polymerization inhibitor, an antioxidant, a sensitizer, a co-sensitizer, a curing accelerator, a heat-curing accelerator, a plasticizer, a diluent, a lipophilizing agent, and a rubber component. Moreover, a well-known additive such as an adhesion promoter capable of facilitating adhesion to a substrate surface and other auxiliaries (such as an anti-foaming agent, a flame retardant, a leveling agent, a peeling promoter, an antioxidant, a perfume, a surface tension modifier, and a chain transfer agent) may be optionally added.

### Surfactant

Examples of the surfactant include various surfactants such as fluorine-based surfactants, nonionic surfactants, cationic surfactants, anionic surfactants, and silicone-based surfactants. Other examples of the surfactant include surfactants described in paragraphs 0238 to 0245 of WO2015/166779A, and the contents of which are incorporated in the present specification.

The present invention is basically configured as described above. The structure according to the embodiment of the invention and the method for producing the structure have been described in detail. However, the present invention is not limited to the embodiment described above. It will be appreciated that various modifications and changes may be made so long as they fall within the scope of the invention.

### Examples

The features of the invention will next be described further specifically by way of Examples. Materials, reagents, amounts and ratios of the materials, operations, etc. shown in the following Examples can be appropriately modified so long as they do not deviate from the gist of the invention. Therefore, the scope of the invention is not limited to the following Examples.

In the configurations used in the Examples, the transmitting antenna element 22 (see Fig. 1) and the receiving antenna element 24 (see Fig. 1) are disposed on the substrate so as to be spaced apart from each other.

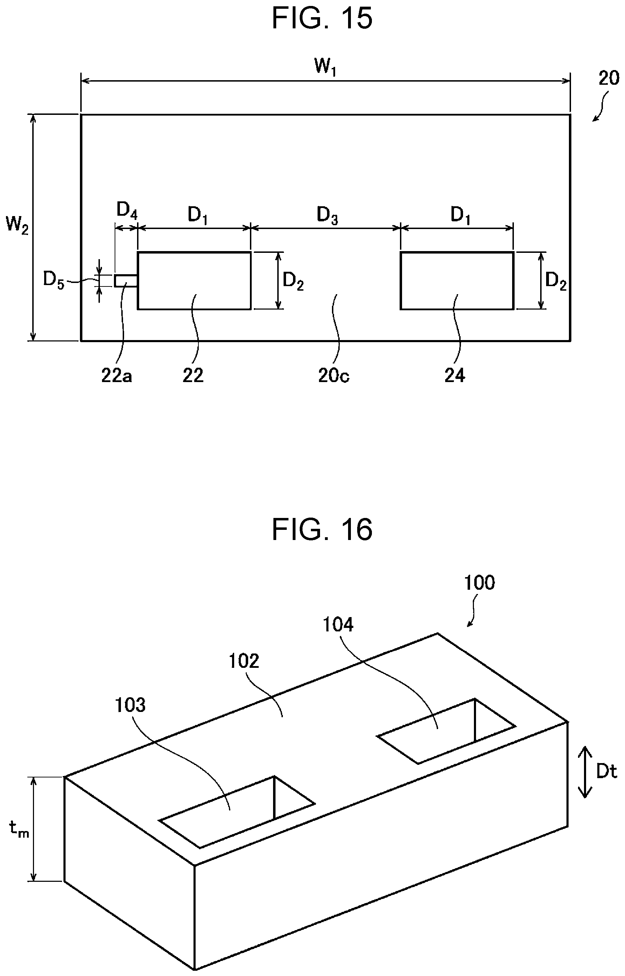

Fig. 15 is a schematic illustration showing the arrangement positions of the substrate 20, the transmitting antenna element 22, and the receiving antenna element 24 used in the Examples.

As shown in Fig. 15, the substrate 20 has a rectangular outer shape. The transmitting antenna element 22, excluding the feeding point, has a rectangular outer shape, and the receiving antenna element 24 has a rectangular outer shape.

The substrate has dimensions of W₁ × W₂ = 6.5 mm × 3 mm, and its thickness is 0.1 mm (100 µm).

The transmitting antenna element has a D₁ of 1.5 mm, a D₂ of 0.75 mm, and a thickness of 18 µm. The feeding point has a D₄ of 0.3 mm, a D₅ of 0.15 mm, and a thickness of 18 µm.

The receiving antenna element has a D₁ of 1.5 mm, a D₂ of 0.75 mm, and a thickness of 18 µm. The distance D₃ between the transmitting antenna element and the receiving antenna element is 2 mm.

The substrate is made of polytetrafluoroethylene (PTFE). Its relative dielectric constant εr is 3.05, and its electrical conductivity is 1×10⁻¹⁶ (S/m).

The transmitting antenna element and the receiving antenna element are made of copper. Their relative dielectric constant εr is 1, and their electrical conductivity is 5.998 × 10⁷ (S/m). Electromagnetic wave shielding and far field gain

In Examples 1 to 39 and Comparative Examples 1 to 27, electric and magnetic fields generated by a high-frequency wave resulting from a 60 GHz high-frequency signal supplied to the transmitting antenna element were measured at the position of the receiving antenna element. The integrated values of the electric and magnetic fields at a position 2 mm from the transmitting antenna element to which the high-frequency signal having a frequency of 60 GHz was supplied were used to compute the electric field attenuation and the magnetic field attenuation in units of decibels (dB). The computed values were negative values. The position 2 mm from the transmitting antenna element corresponds to the distance between the transmitting antenna element and the receiving antenna element.

The integrated values of the electric and magnetic fields at the position 2 mm from the transmitting antenna element are used to evaluate the electromagnetic wave shielding ability.

The integrated values of the electric and magnetic fields were computed by solving the Helmholtz wave equations shown in the following mathematical formulas (a) and (b) using the RF module and physics study of electromagnetic waves (frequency domain) in COMSOL Multiphysics (registered trademark).

In the following mathematical formulas (a) and (b), j represents the imaginary unit. εᵣ = ε' - ε" × j. Here, ε' is the real part of the dielectric constant, and ε" is the imaginary part of the dielectric constant.$μr = μ ′ - μ " \times j .$ Here, µ" is the real part of the magnetic permeability, and µ" is the imaginary part of the magnetic permeability.${k}_{0} = ω {\left({μ}_{0}⋅{ε}_{0}\right)}^{1 / 2} \left({m}^{- 1}\right) .$ Here, ω is the angular velocity, and i is the current. µ₀ is the magnetic permeability in a vacuum, and ε₀ is the dielectric constant in a vacuum. η₀ = (µ₀·ε₀)^{1/2}(Ω) ${μ}_{0} = 1.257 \times {10}^{- 6} \left(H/m\right) , and {ε}_{0} = 8.854 \times {10}^{- 12} \left(F/m\right) .$$∇ \times \left(\frac{∇ \times E}{{μ}_{r}}\right) - {k}_{0}^{2} {ε}_{r} E = - {jk}_{0} {η}_{0} i$ (a) $∇ \times \left(\frac{∇ \times H}{{ε}_{r}}\right) - {k}_{0}^{2} {μ}_{r} H = ∇ \times \left(\frac{i}{{ε}_{r}}\right)$ (b)

The integrated electric field intensity (dB) at the position of the receiving antenna element was used to compute the intensity attenuation as a negative intensity (dB) relative to the case with no magnetic material. The emw.gaindBEfar function in the COMSOL (registered trademark) system was used to compute the maximum value of the far field gain. The minimum value of the emw.gaindBEfar for the far field gain was 0 dB, and its maximum value was 6.9 dB.

The integrated values of the electric and magnetic fields at the position 2 mm from the transmitting antenna element were used to evaluate the electromagnetic wave shielding ability according to the following evaluation criteria.

### Evaluation criteria

A: -6 dB or more
B: -4 dB or more and less than -6 dB
C: -2 dB or more and less than -4 dB
D: Less than -2 dB

The maximum value of the far field gain was used to evaluate the far field gain according to the following evaluation criteria.

### Evaluation criteria

A: 6 dB or more
B: 4 dB or more and less than 6 dB
C: 2 dB or more and less than 4 dB
D: Less than 2 dB

In Examples 3, 21, 28, and 35 and Comparative Examples 2, 9, 16, and 23, the frequency of the high-frequency signal was changed to 47 GHz.

In Examples 4, 22, 29, and 36 and Comparative Examples 3, 10, 17, and 24, the frequency of the high-frequency signal was changed to 28 GHz.

In Examples 5, 23, 30, and 37 and Comparative Examples 4, 11, 18, and 25, the frequency of the high-frequency signal was changed to 18 GHz.

In Examples 6, 24, 31, and 38 and Comparative Examples 5, 12, 19, and 26, the frequency of the high-frequency signal was changed to 14 GHz.

In Examples 7, 25, 32, and 39 and Comparative Examples 6, 13, 20, and 27, the frequency of the high-frequency signal was changed to 2 GHz.

The results of evaluation of the electromagnetic wave shielding ability and the far field gain in Examples 1 to 39 and Comparative Examples 1 to 27 are shown in Tables 9 and 10 presented later.

### Examples 1 to 39 and Comparative Examples 1 to 27

Various components were mixed according to the formulations shown in Tables 1 to 8 presented later to prepare compositions containing magnetic material particles. The components used are as follows. Magnetic material particles

### - Barium ferrite M-1: The following method was used for the synthesis.

400.0 g of water held at a temperature of 35°C was stirred. 57.0 g of iron (III) chloride hexahydrate [FeCl₃·6H₂O], 25.4 g of barium chloride dihydrate [BaCl₂·2H₂O], and 10.2 g of aluminum chloride hexahydrate [AlCl₃·6H₂O] were dissolved in 216.0 g of water to prepare an aqueous raw material solution, and 113.0 g of water was added to 181.3 g of an aqueous sodium hydroxide solution with a concentration of 5 mol/L to prepare a solution. The entire volume of the aqueous raw material solution and the entire volume of the prepared solution were added at the same time to the above water under stirring at a flow rate of 10 mL/min to obtain a first solution.

Next, the temperature of the first solution was adjusted to 25°C. With the temperature of the solution held at 25°C, 39.8 g of an aqueous sodium hydroxide solution with a concentration of 1 mol/L was added to obtain a second solution. The pH (hydrogen ion concentration) of the obtained second solution was 10.5±0.5. The pH was measured using a desktop pH meter (F-71 manufactured by Horiba, Ltd.).

Next, the second solution was stirred for 15 minutes to obtain a solution containing a precipitate serving as a precursor of magnetoplumbite type hexagonal ferrite (a precursor-containing solution).

Next, the precursor-containing solution was subjected to centrifugal treatment (rotation speed: 2000 revolutions per minute (rpm), rotation time: 10 minutes) three times, and the resulting precipitate was collected and washed with water.

Next, the collected precipitate was dried in an oven having an internal atmosphere temperature of 95°C for 12 hours to obtain a precursor powder.

Next, the precursor powder was placed in a muffle furnace. The temperature inside the furnace was set to 1100°C, and the precursor powder was fired in an air atmosphere for 4 hours to obtain a sintered product in lump form.

Next, the obtained sintered product was pulverized for 90 seconds using a cutter mill (Wonder Crusher WC-3 manufactured by OSAKA CHEMICAL Co., Ltd.) serving as a crusher with the variable speed dial of the crusher set to "5" (rotation speed: about 10000 to 15000 rpm) to obtain a magnetic powder (barium ferrite M-1).

The number average particle diameter of the barium ferrite M-1 was 110 nm.

The crystal structure of the magnetic material forming the magnetic powder was examined by X-ray diffraction analysis. The measurement device used was the X'Pert Pro available from PANalytical, which is a powder X-ray diffractometer. The measurement conditions are shown below.

### Measurement conditions

X-ray source: CuKα line
[wavelength: 1.54 Å (0.154 nm), power: 40 mA, 45 kV]
Scanning range: 20° < 2θ < 70°
Scanning intervals: 0.05°
Scanning speed: 0.75°/min

The results of the X-ray diffraction analysis showed that the obtained magnetic powder was a powder of single-phase magnetoplumbite type hexagonal ferrite having a magnetoplumbite crystal structure and including no crystal structures other than the magnetoplumbite crystal structure.

### - Strontium ferrite M-2: The following method was used for the synthesis.

46.3 g of strontium carbonate [SrCO₃ manufactured by FUJIFILM Wako Pure Chemical Corporation], 255.1 g or α-iron oxide (III) [α-Fe₂O₃ manufactured by FUJIFILM Wako Pure Chemical Corporation], and 14.8 g of aluminum oxide [Al₂O₃ manufactured by FUJIFILM Wako Pure Chemical Corporation, average particle size: 40 nm] were stirred for 2 minutes using the Wonder Crush/Mill (type WDL-1 manufactured by OSAKA CHEMICAL Co., Ltd.).

300 g of water and 30.0 g of a flux (strontium chloride hexahydrate [SrCl₂·6H₂O manufactured by FUJIFILM Wako Pure Chemical Corporation])) were added to the obtained mixture, and the resulting mixture was stirred using a Waring blender (type 7011HSJ manufactured by WARING) for 30 minutes and then dried in a dryer with an internal atmosphere temperature of 95°C.

Next, the Wonder Crush/Mill was used to stir and pulverize the dried mixture for 2 minutes to obtain a precursor of magnetic powder. The obtained precursor was placed in a muffle furnace. With the temperature inside the furnace set to a temperature condition of 1250°C, the precursor was fired in an air atmosphere for 4 hours to obtain a sintered product. The obtained sintered product was stirred and pulverized for 2 minutes using the Wonder Crush/Mill, washed repeatedly with water, and then dried in a dryer with an internal atmosphere temperature of 95°C.

Then the Wonder Crush/Mill was used to stir and pulverize the resulting product for 2 minutes to obtain a magnetic powder (strontium ferrite M-2).

The number average particle diameter of the strontium ferrite M-2 was 90 nm.
- M-3: MC-617 (manufactured by TODA KOGYO CORP., 47 GHz)
- M-4: BMXF-5 (manufactured by BGRIMM, 28 GHz)
- M-5: CoTi-substituted Ba ferrite (synthesized in-house)
- M-6: ZnCoNb-substituted Ba ferrite (synthesized in-house)
- M-7: Co-substituted magnetite (synthesized in-house)
- M-8: Ni-Zn-Co-based ferrite (manufactured by Japan Metals & Chemicals Co., Ltd., volume average particle diameter (D50): 40 µm)
- M-9: Mn-Zn ferrite (manufactured by Powdertech Co., Ltd., volume average particle diameter (D50): 0.2 µm)
- M-10: Mn-Zn ferrite (manufactured by Powdertech Co., Ltd., volume average particle diameter (D50): 1.0 µm)
- M-11: Mn-Zn ferrite (manufactured by Powdertech Co., Ltd., volume average particle diameter (D50): 3 µm)
- M-12: Mn ferrite (manufactured by Powdertech Co., Ltd., volume average particle diameter (D50): 0.4 µm)
- M-13: Mn ferrite (manufactured by Powdertech Co., Ltd., volume average particle diameter (D50): 1.6 µm)
- M-14: Mn ferrite (manufactured by Powdertech Co., Ltd., volume average particle diameter (D50) 4 µm)
- M-15: KUAMET NC1 (manufactured by EPSON ATMIX Corporation, volume average particle diameter (D50): 25 µm)
- M-16: ATFIN-NC1 (manufactured by EPSON ATMIX Corporation, volume average particle diameter (D50): 3 µm)
- M-17: AW2-08PF3F (manufactured by EPSON ATMIX Corporation, volume average particle diameter (D50): 3 µm)

The number average particle diameter of the magnetic material particles was measured as follows. A particle photograph of the magnetic material particles was captured using a transmission electron microscope at a capturing magnification of 100,000x and printed on photographic paper such that the total magnification was 500,000x, as described above. Then a digitizer was used to trace the contours of the particles (primary particles), and the diameters of circles having the same areas as the traced regions (equivalent circle diameters) were computed.

The volume average particle diameter of the magnetic material particles is the median diameter (D50) as described above and was determined using a particle size distribution curve representing a volume-based frequency distribution of the magnetic material particles obtained using "LA960N" (laser diffraction/scattering particle diameter distribution measurement device) manufactured by HORIBA Ltd.

### Binder

- B-1: Poly(allyl methacrylate-methacrylate) resin (molecular weight: about 42000) represented by the following structural formulas. 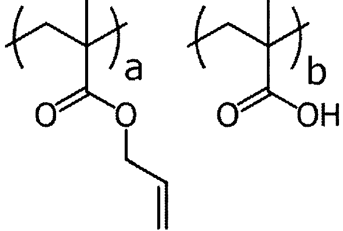
   a / b = 80 / 20 (mol%)
   Mw=ca. 41000
- B-2: Poly(benzyl methacrylate-methacrylate) resin (molecular weight: about 11000) represented by the following structural formulas. 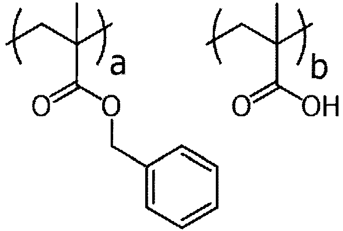
   a / b = 53.3 / 46.7 (mol%)
   Mw=ca. 12000

### Dispersing agent

- C-1: Hinoact T-6000 (Kawaken Fine Chemicals Co., Ltd.).
- C-2: (Synthesized product (15)) represented by the following structural formulas. 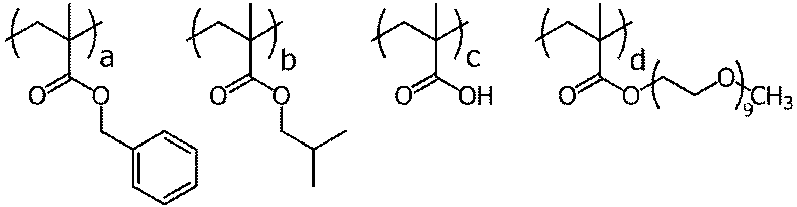
   a / b / c / d = 30 / 38 / 28 / 4 (mol%)
   Mw=ca. 13000
- C-3: (Synthesized product (25)) represented by the following structural formulas. 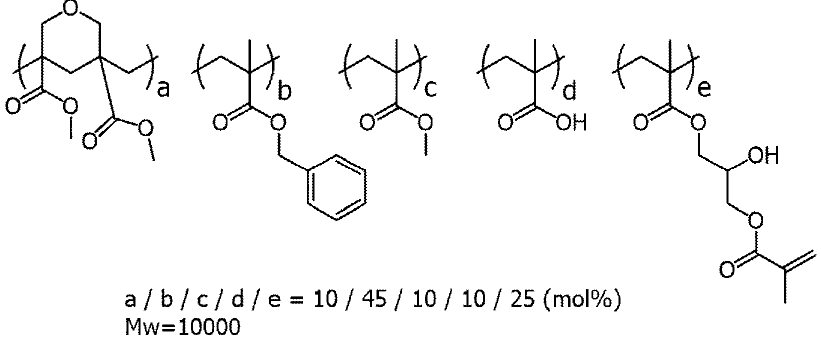
- C-4: (Synthesized product (38)) represented by the following structural formulas.

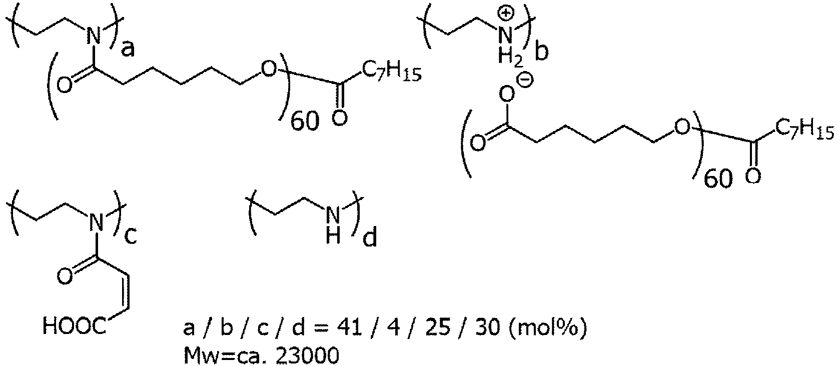

### Thixotropic agent

- D-1: FLOWNON RCM-100 (aliphatic ester/aromatic ester, KYOEISHA CHEMICAL Co., Ltd.)
- D-2: TALEN VA705B (higher fatty acid amide, KYOEISHA CHEMICAL Co., Ltd.)

### Curing agent

- E-1: RIKACID MTA-15 (New Japan Chemical Co., Ltd.)
- E-2: 4-4-Diaminodiphenylsulfone (FUJIFILM Wako Pure Chemical Corporation)

### Epoxy compound

- F-1: DENACOL EX-314 (Nagase & Co., Ltd.)
- F-2: JER871 (Mitsubishi Chemical Corporation)
- F-3: jER890 (Mitsubishi Chemical Corporation)
- F-4: 4,4'-Methylenebis(N,N-diglycidylaniline) (TOKYO CHEMICAL INDUSTRY Co., Ltd.)
- F-5: 1,2-Cyclohexanedicarboxylic acid diglycidyl ester (TOKYO CHEMICAL INDUSTRY Co., Ltd.)
- F-6: Ethylhexyl glycidyl ether (TOKYO CHEMICAL INDUSTRY Co., Ltd.)
- F-7: DENACOL EX-614 (Nagase & Co., Ltd.)

### Solvent

G-1: Glycerol triacetate (FUJIFILM Wako Pure Chemical Corporation)
G-2: 1,4-Butanediol diacetate (1,4-BDDA), boiling point: 232°C

### Example 1

Example 1 has the configuration shown in Fig. 1 and referred to as shape 1.

In Example 1, wiring lines were formed on the substrate using photolithography and used as power supply copper wiring lines for the transmitting antenna element and the receiving antenna element. Then an FR-4 layer with a thickness of about 500 µm was formed on the back surface side of the substrate. Then a microdrill with a diameter of 125 µm was used to form through holes passing though the substrate around the formation region of the transmitting antenna element and the formation region of the receiving antenna element.

The through holes each have a circular opening as shown in Fig. 2. The diameter of the circular opening is 0.31 mm. The spacing D₆ between the through holes is 0.31 mm.

In Example 1, formulation 1 was used for the composition containing the magnetic material particles.

The composition containing the magnetic material particles was applied by screen printing to the front surface of the substrate, and the through holes were evacuated from their lower portions to fill the upper portions of the through holes with the magnetic material particles.

Next, heat treatment was performed at a temperature of 150°C for 10 minutes and then at a temperature of 200°C for 50 minutes to heat-cure the embedded magnetic material, and magnetic material portions were thereby formed. The magnetic material layer protruding from the upper surface of the substrate and the back surface of the FR-4 layer was removed by polishing for planarization. Next, a copper film was formed on the front surface of the substrate by electrolytic plating. Next, photolithography and wet etching were used to form the transmitting antenna element and the receiving antenna element on the front surface of the substrate. The structure in Example 1 was thereby formed.

### Example 2

Example 2 is the same as Example 1 except that formulation 2 was used for the composition containing the magnetic material particles.

### Example 3

Example 3 is the same as Example 1 except that formulation 3 was used for the composition containing the magnetic material particles and that the frequency of the high-frequency signal used to determine the electric field attenuation and the magnetic field attenuation was changed to 47 GHz.

### Example 4

Example 4 is the same as Example 1 except that formulation 4 was used for the composition containing the magnetic material particles and that the frequency of the high-frequency signal used to determine the electric field attenuation and the magnetic field attenuation was changed to 28 GHz.

### Example 5

Example 5 is the same as Example 1 except that formulation 5 was used for the composition containing the magnetic material particles and that the frequency of the high-frequency signal used to determine the electric field attenuation and the magnetic field attenuation was changed to 18 GHz.

### Example 6

Example 6 is the same as Example 1 except that formulation 6 was used for the composition containing the magnetic material particles and that the frequency of the high-frequency signal used to determine the electric field attenuation and the magnetic field attenuation was changed to 14 GHz.

### Example 7

Example 7 is the same as Example 1 except that formulation 7 was used for the composition containing the magnetic material particles and that the frequency of the high-frequency signal used to determine the electric field attenuation and the magnetic field attenuation was changed to 2 GHz.

### Example 8

Example 8 is the same as Example 1 except that formulation 8 was used for the composition containing the magnetic material particles.

### Example 9

Example 9 is the same as Example 1 except that formulation 9 was used for the composition containing the magnetic material particles.

### Example 10

Example 10 is the same as Example 1 except that formulation 10 was used for the composition containing the magnetic material particles.

### Example 11

Example 11 is the same as Example 1 except that formulation 11 was used for the composition containing the magnetic material particles.

### Example 12

Example 12 is the same as Example 1 except that formulation 12 was used for the composition containing the magnetic material particles.

### Example 13

Example 13 is the same as Example 1 except that formulation 13 was used for the composition containing the magnetic material particles.

### Example 14

Example 14 is the same as Example 1 except that formulation 14 was used for the composition containing the magnetic material particles.

### Example 15

Example 15 is the same as Example 1 except that formulation 15 was used for the composition containing the magnetic material particles.

### Example 16

Example 16 is the same as Example 1 except that formulation 16 was used for the composition containing the magnetic material particles.

### Example 17

Example 17 is the same as Example 1 except that formulation 17 was used for the composition containing the magnetic material particles.

### Example 18

Example 18 is the same as Example 1 except that formulation 18 was used for the composition containing the magnetic material particles.

### Example 19

Example 19 has the configuration shown in Fig. 8 and referred to as shape 2.

Example 19 is the same as Example 1 except that the magnetic material wall portion and the magnetic material portion were arranged as shown in Fig. 8 and that no magnetic material portions were formed in the substrate. In Example 19, no FR-4 layer was disposed on the substrate.

In Example 19, the magnetic material wall portion has the size shown in Fig. 9. The size of the magnetic material wall portion is W₃ × W₄ = 9.5 mm × 6 mm. The thickness W₅ of the magnetic material wall portion is 1 mm. The space W₆ between the magnetic material wall portion and the substrate 20 is 0.5 mm.

In Example 19, formulation 1 was used for the composition containing the magnetic material particles, and a patterned portion for the magnetic material portion was formed by a pattern printing method. Next, the magnetic material particle-containing composition with formulation 1 was used to form a patterned portion for the magnetic material wall portion by a pattern printing method. The patterned portion for the magnetic material wall portion was formed on the outer peripheral portion of the front surface of the magnetic material portion with the front surface of the patterned portion for the magnetic material portion serving as the bottom surface of the magnetic material wall portion. Next, heat treatment was performed at a temperature of 150°C for 10 minutes and then at a temperature of 200°C for 50 minutes to heat-cure the composition, and the magnetic material portion and the magnetic material wall portion were formed integrally. The integrated magnetic material portion and magnetic material wall portion had a concave section.

The substrate having the transmitting antenna element and the receiving antenna element formed on its front surface was prepared. No magnetic material portions were formed in the substrate.

Next, the substrate was disposed such that its back surface faced the bottom surface of the concave section, i.e., the front surface of the magnetic material portion. Then a thermosetting adhesive was used to fix the substrate onto the front surface of the magnetic material portion. The structure in Example 19 was thereby formed.

### Example 20

Example 20 is the same as Example 19 except that formulation 2 was used for the composition containing the magnetic material particles.

### Example 21

Example 21 is the same as Example 19 except that formulation 3 was used for the composition containing the magnetic material particles and that the frequency of the high-frequency signal used to determine the electric field attenuation and the magnetic field attenuation was changed to 47 GHz.

### Example 22

Example 22 is the same as Example 19 except that formulation 4 was used for the composition containing the magnetic material particles and that the frequency of the high-frequency signal used to determine the electric field attenuation and the magnetic field attenuation was changed to 28 GHz.

### Example 23

Example 23 is the same as Example 19 except that formulation 5 was used for the composition containing the magnetic material particles and that the frequency of the high-frequency signal used to determine the electric field attenuation and the magnetic field attenuation was changed to 18 GHz.

### Example 24

Example 24 is the same as Example 19 except that formulation 6 was used for the composition containing the magnetic material particles and that the frequency of the high-frequency signal used to determine the electric field attenuation and the magnetic field attenuation was changed to 14 GHz.

### Example 25

Example 25 is the same as Example 19 except that formulation 7 was used for the composition containing the magnetic material particles and that the frequency of the high-frequency signal used to determine the electric field attenuation and the magnetic field attenuation was changed to 2 GHz.

### Example 26

Example 26 has the configuration shown in Fig. 12 and referred to as shape 3.

Example 26 is the same as Example 1 except that the magnetic material layer was arranged as shown in Fig. 12 and that no magnetic material portions were formed in the substrate. In Example 26, no FR-4 layer was formed on the substrate.

In Example 26, the magnetic material layer has the size shown in Fig. 13. The size of the magnetic material layer is W₇ × W₈ = 9.5 mm × 6 mm. The thickness of the magnetic material layer is 0.9 mm.

The width D₇ of the first magnetic material portion, the width D₈ of the second magnetic material portion, and the width D₉ of the third magnetic material portion are 1.9 mm. The gap distance D₁₀ between the first magnetic material portion and the second magnetic material portion is 2 mm. The gap distance D₁₁ between the first magnetic material portion and the third magnetic material portion is 1.7 mm. The length W₉ of the first magnetic material portion, the second magnetic material portion, and the third magnetic material portion is 4 mm.

The magnetic material layer was formed by applying the magnetic material particle-containing composition with formulation 1 to the front surface of the substrate using a screen printing method. Specifically, the composition was applied in a pattern corresponding to the magnetic material layer. Next, heat treatment was performed at a temperature of 150°C for 10 minutes and then at a temperature of 200°C for 50 minutes to heat-cure the composition, and the magnetic material layer was thereby formed. The structure in Example 26 was thereby formed.

### Example 27

Example 27 is the same as Example 26 except that formulation 2 was used for the composition containing the magnetic material particles.

### Example 28

Example 28 is the same as Example 26 except that formulation 3 was used for the composition containing the magnetic material particles and that the frequency of the high-frequency signal used to determine the electric field attenuation and the magnetic field attenuation was changed to 47 GHz.

### Example 29

Example 29 is the same as Example 26 except that formulation 4 was used for the composition containing the magnetic material particles and that the frequency of the high-frequency signal used to determine the electric field attenuation and the magnetic field attenuation was changed to 28 GHz.

### Example 30

Example 30 is the same as Example 26 except that formulation 5 was used for the composition containing the magnetic material particles and that the frequency of the high-frequency signal used to determine the electric field attenuation and the magnetic field attenuation was changed to 18 GHz.

### Example 31

Example 31 is the same as Example 26 except that formulation 6 was used for the composition containing the magnetic material particles and that the frequency of the high-frequency signal used to determine the electric field attenuation and the magnetic field attenuation was changed to 14 GHz.

### Example 32

Example 32 is the same as Example 26 except that formulation 7 was used for the composition containing the magnetic material particles and that the frequency of the high-frequency signal used to determine the electric field attenuation and the magnetic field attenuation was changed to 2 GHz.

### Example 33

Example 33 has the configuration shown in Fig. 14 and referred to as shape 4.

Example 33 is the same as Example 1 except that the magnetic material layer was arranged as shown in Fig. 14 and that no magnetic material portions were formed in the substrate. In Example 33, no FR-4 layer was disposed on the substrate.

In Example 33, the size of magnetic material layer is the same as that in Example 26. In Example 33, the magnetic material layer was formed using the same procedure as in Example 26 except that the magnetic material layer was formed on the back surface of the substrate.

### Example 34

Example 34 is the same as Example 33 except that formulation 2 was used for the composition containing the magnetic material particles.

### Example 35

Example 35 is the same as Example 33 except that formulation 3 was used for the composition containing the magnetic material particles and that the frequency of the high-frequency signal used to determine the electric field attenuation and the magnetic field attenuation was changed to 47 GHz.

### Example 36

Example 36 is the same as Example 33 except that formulation 4 was used for the composition containing the magnetic material particles and that the frequency of the high-frequency signal used to determine the electric field attenuation and the magnetic field attenuation was changed to 28 GHz.

### Example 37

Example 37 is the same as Example 33 except that formulation 5 was used for the composition containing the magnetic material particles and that the frequency of the high-frequency signal used to determine the electric field attenuation and the magnetic field attenuation was changed to 18 GHz.

### Example 38

Example 38 is the same as Example 33 except that formulation 6 was used for the composition containing the magnetic material particles and that the frequency of the high-frequency signal used to determine the electric field attenuation and the magnetic field attenuation was changed to 14 GHz.

### Example 39

Example 39 is the same as Example 33 except that formulation 7 was used for the composition containing the magnetic material particles and that the frequency of the high-frequency signal used to determine the electric field attenuation and the magnetic field attenuation was changed to 2 GHz.

### Comparative Examples 1 to 27

Comparative Example 1 has the configuration shown in Fig. 15 and referred to as shape 5.

Comparative Example 1 is the same as Example 1 except that no magnetic material portions were provided. In Comparative Example 1, no FR-4 layer was disposed on the substrate. In Comparative Example 1, the size of the substrate, the size of the transmitting antenna element, and the size of the receiving antenna element are the same as those shown in Fig. 15.

Comparative Examples 1 to 6 have the configuration with no magnetic material portions. Therefore, "-" was placed in the formulation column in Table 10 shown later.

### Comparative Example 2

Comparative Example 2 is the same as Comparative Example 1 except that the frequency of the high-frequency signal used to determine the electric field attenuation and the magnetic field attenuation was changed to 47 GHz.

### Comparative Example 3

Comparative Example 3 is the same as Comparative Example 1 except that the frequency of the high-frequency signal used to determine the electric field attenuation and the magnetic field attenuation was changed to 28 GHz.

### Comparative Example 4

Comparative Example 4 is the same as Comparative Example 1 except that the frequency of the high-frequency signal used to determine the electric field attenuation and the magnetic field attenuation was changed to 18 GHz.

### Comparative Example 5

Comparative Example 5 is the same as Comparative Example 1 except that the frequency of the high-frequency signal used to determine the electric field attenuation and the magnetic field attenuation was changed to 14 GHz.

### Comparative Example 6

Comparative Example 6 is the same as Comparative Example 1 except that the frequency of the high-frequency signal used to determine the electric field attenuation and the magnetic field attenuation was changed to 2 GHz.

### Comparative Example 7

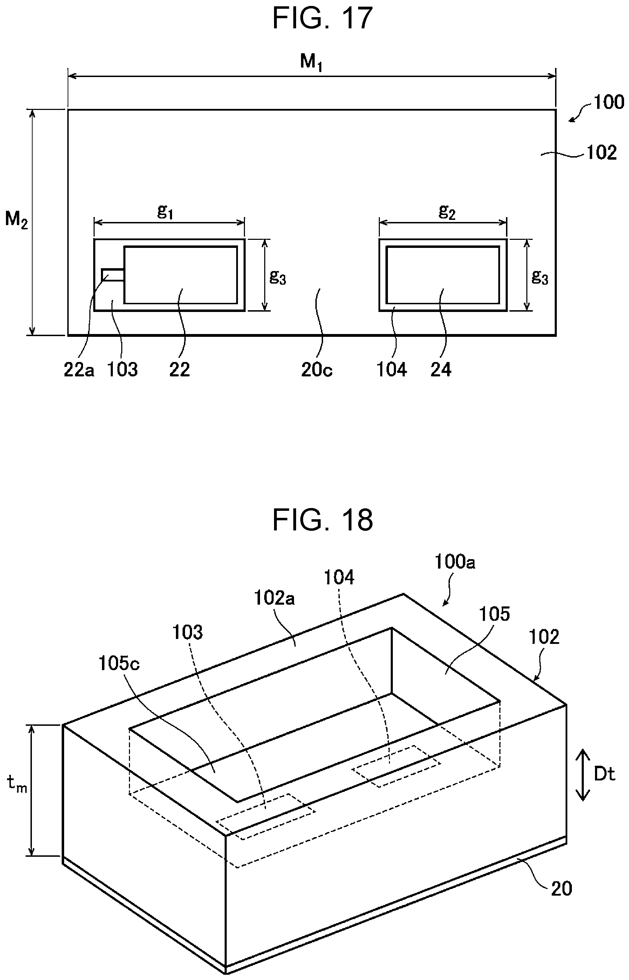

Comparative Example 7 has the configuration shown in Figs. 16 and 17 and referred to as shape 6.

Comparative Example 7 is the same as Example 1 except that a magnetic material portion 102 shown in Figs. 16 and 17 was used and that no magnetic material portions were formed in the substrate 20. In Comparative Example 7, no FR-4 layer was disposed on the substrate.

The structure 100 in Comparative Example 7 has the magnetic material portion 102. The magnetic material portion 102 has a first opening portion 103 that forms an open space above the transmitting antenna element and a second opening portion 104 that forms an open space above the receiving antenna element.

The size of the magnetic material portion 102 is the same as the size shown in Fig. 17.

The size of the magnetic material portion in Comparative Example 7 is M₁ × M₂ (see Fig. 17) = 6.5 mm × 3 mm. Specifically, the size of the magnetic material portion is the same as the size of the substrate. The thickness tm of the magnetic material portion (see Fig. 16) is 0.9 mm.

In the first opening portion 103, g₁ × g₃ (see Fig. 17) is 2 mm × 0.95 mm. In the second opening portion 104, g₂ × g₃ (see Fig. 17) is 1.7 mm × 0.95 mm.

The magnetic material portion was formed by applying the magnetic material particle-containing composition with formulation 1 to the front surface of the substrate by a screen printing method to form a pattern for the magnetic material portion. Next, heat treatment was performed at a temperature of 150°C for 10 minutes and then at a temperature of 200°C for 50 minutes to heat-cure the composition. The structure 100 in Comparative Example 7 was thereby formed.

### Comparative Example 8

Comparative Example 8 is the same as Comparative Example 7 except that formulation 2 was used for the composition containing the magnetic material particles.

### Comparative Example 9

Comparative Example 9 is the same as Comparative Example 7 except that formulation 3 was used for the composition containing the magnetic material particles and that the frequency of the high-frequency signal used to determine the electric field attenuation and the magnetic field attenuation was changed to 47 GHz.

### Comparative Example 10

Comparative Example 10 is the same as Comparative Example 7 except that formulation 4 was used for the composition containing the magnetic material particles and that the frequency of the high-frequency signal used to determine the electric field attenuation and the magnetic field attenuation was changed to 28 GHz.

### Comparative Example 11

Comparative Example 11 is the same as Comparative Example 7 except that formulation 5 was used for the composition containing the magnetic material particles and that the frequency of the high-frequency signal used to determine the electric field attenuation and the magnetic field attenuation was changed to 18 GHz.

### Comparative Example 12

Comparative Example 12 is the same as Comparative Example 7 except that formulation 6 was used for the composition containing the magnetic material particles and that the frequency of the high-frequency signal used to determine the electric field attenuation and the magnetic field attenuation was changed to 14 GHz.

### Comparative Example 13

Comparative Example 13 is the same as Comparative Example 7 except that formulation 7 was used for the composition containing the magnetic material particles and that the frequency of the high-frequency signal used to determine the electric field attenuation and the magnetic field attenuation was changed to 2 GHz.

### Comparative Example 14

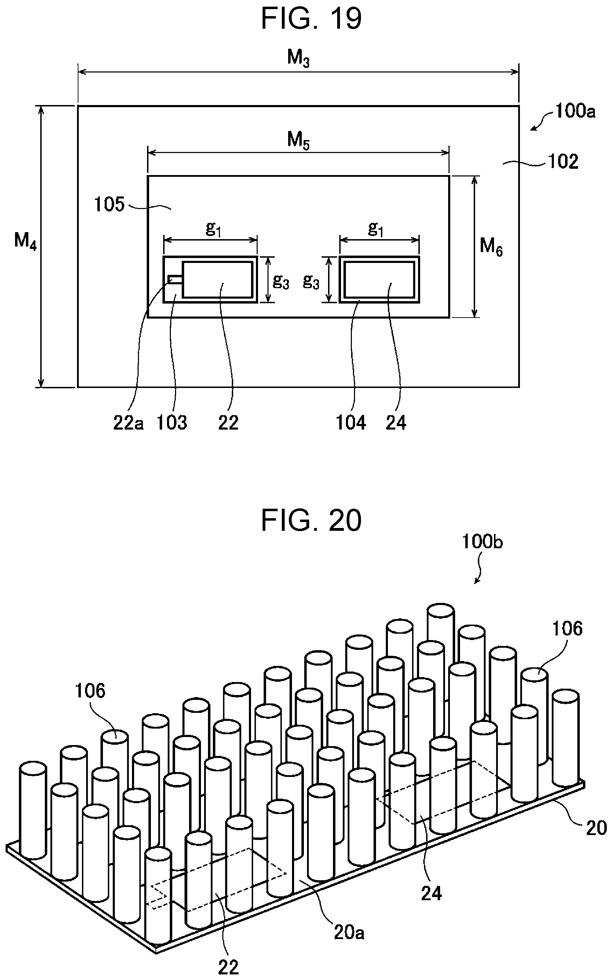

Comparative Example 14 is a structure 100a having the configuration shown in Figs. 18 and 19 and referred to as shape 7.

Comparative Example 14 is the same as Example 1 except that a magnetic material portion 102 shown in Fig. 18 was used and that no magnetic material portions were formed in the substrate 20. In Comparative Example 14, no FR-4 layer was disposed on the substrate.

The magnetic material portion 102 in Comparative Example 14 has a concave section 105. A first opening portion 103 that forms an open space above the transmitting antenna element and a second opening portion 104 that forms an open space above the receiving antenna element are provided on a bottom surface 105c of the concave section 105.

The size of the magnetic material portion in Comparative Example 14 is M₃ × M₄ (see Fig. 19) = 9.5 mm × 6 mm. The thickness tm of the magnetic material portion (see Fig. 18) is 2 mm. The opening size of the concave section 105 is M₅ × M₆ (see Fig. 19) = 6 mm × 3 mm.

In the first opening portion 103, g₁ × g₃ (see Fig. 19) is 2 mm × 0.95 mm. In the second opening portion 104, g₂ × g₃ (see Fig. 19) is 1.7 mm × 0.95 mm. The first opening portion 103 and the second opening portion 104 are formed at positions 1 mm below the front surface 102a of the magnetic material portion 102 in the thickness direction Dt.

The magnetic material portion was formed by applying the magnetic material particle-containing composition with formulation 1 to the front surface of the substrate by a screen printing method to form a pattern for the magnetic material portion. Next, heat treatment was performed at a temperature of 150°C for 10 minutes and then at a temperature of 200°C for 50 minutes to heat-cure the composition. The structure 100a in Comparative Example 14 was thereby formed.

### Comparative Example 15

Comparative Example 15 is the same as Comparative Example 14 except that formulation 2 was used for the composition containing the magnetic material particles.

### Comparative Example 16

Comparative Example 16 is the same as Comparative Example 14 except that formulation 3 was used for the composition containing the magnetic material particles and that the frequency of the high-frequency signal used to determine the electric field attenuation and the magnetic field attenuation was changed to 47 GHz.

### Comparative Example 17

Comparative Example 17 is the same as Comparative Example 14 except that formulation 4 was used for the composition containing the magnetic material particles and that the frequency of the high-frequency signal used to determine the electric field attenuation and the magnetic field attenuation was changed to 28 GHz.

### Comparative Example 18

Comparative Example 18 is the same as Comparative Example 14 except that formulation 5 was used for the composition containing the magnetic material particles and that the frequency of the high-frequency signal used to determine the electric field attenuation and the magnetic field attenuation was changed to 18 GHz.

### Comparative Example 19

Comparative Example 19 is the same as Comparative Example 14 except that formulation 6 was used for the composition containing the magnetic material particles and that the frequency of the high-frequency signal used to determine the electric field attenuation and the magnetic field attenuation was changed to 14 GHz.

### Comparative Example 20

Comparative Example 20 is the same as Comparative Example 14 except that formulation 7 was used for the composition containing the magnetic material particles and that the frequency of the high-frequency signal used to determine the electric field attenuation and the magnetic field attenuation was changed to 2 GHz.

### Comparative Example 21

Comparative Example 21 is a structure 100b having the configuration shown in Fig. 20 and referred to as shape 8. In Fig. 20, part of magnetic material portions 106 are omitted.

Comparative Example 21 is the same as Example 1 except that the magnetic material portions 106 shown in Fig. 20 were provided and that no magnetic material portions were formed in the substrate 20.

In the configuration of Comparative Example 21, the magnetic material portions 106 are disposed on the side opposite to that in Example 1. In Comparative Example 21, the magnetic material portions 106 are present only on the substrate, and no magnetic material portions are present within the substrate. The magnetic material portions 106 extend in the thickness direction Dt, are spaced from each other, and disposed parallel to each other, as are the magnetic material portions 26 (see Fig. 1) described above, and their lengths in the thickness direction Dt are the same.

In Comparative Example 21, the magnetic material portions 106 are disposed on the front surface 20a of the substrate 20. No magnetic material portions 106 are disposed on the transmitting antenna element and the receiving antenna element.

First, a copper film was formed on the front surface of the substrate by an electrolytic plating method. Next, photolithography and wet etching were used to form the transmitting antenna element and the receiving antenna element on the front surface of the substrate.

Next, an FR-4 layer with a thickness of about 500 µm was formed on the front surface of the substrate. Then a microdrill with a diameter of 125 µm was used to form through holes passing though the substrate and the FR-4 layer around the transmitting antenna element and the receiving antenna element. The through holes each have a circular outer shape as shown in Fig. 2. The diameter of the circular shape is 0.31 mm. The spacing D₆ between the through holes is 0.31 mm.

In Comparative Example 21, formulation 1 was used for the composition containing the magnetic material particles.

The magnetic material particle-containing composition with formulation 1 was applied to the front surface of the FR-4 layer by a screen printing method, and the through holes in the FR-4 layer were evacuated from the back surface side of the substrate to fill the through holes with the magnetic material particles.

Next, heat treatment was performed at a temperature of 150°C for 10 minutes and then at a temperature of 200°C for 50 minutes to heat-cure the embedded magnetic material, and the magnetic material portions were thereby formed. The magnetic material layer protruding from the back surface of the substrate and the front surface of the FR-4 layer was removed by polishing for planarization. The structure 100b in Comparative Example 21 was thereby formed. Comparative Example 22

Comparative Example 22 is the same as Comparative Example 21 except that formulation 2 was used for the composition containing the magnetic material particles.

### Comparative Example 23

Comparative Example 23 is the same as Comparative Example 21 except that formulation 3 was used for the composition containing the magnetic material particles and that the frequency of the high-frequency signal used to determine the electric field attenuation and the magnetic field attenuation was changed to 47 GHz.

### Comparative Example 24

Comparative Example 24 is the same as Comparative Example 21 except that formulation 4 was used for the composition containing the magnetic material particles and that the frequency of the high-frequency signal used to determine the electric field attenuation and the magnetic field attenuation was changed to 28 GHz.

### Comparative Example 25

Comparative Example 25 is the same as Comparative Example 21 except that formulation 5 was used for the composition containing the magnetic material particles and that the frequency of the high-frequency signal used to determine the electric field attenuation and the magnetic field attenuation was changed to 18 GHz.

### Comparative Example 26

Comparative Example 26 is the same as Comparative Example 21 except that formulation 6 was used for the composition containing the magnetic material particles and that the frequency of the high-frequency signal used to determine the electric field attenuation and the magnetic field attenuation was changed to 14 GHz.

### Comparative Example 27

Comparative Example 27 is the same as Comparative Example 21 except that formulation 7 was used for the composition containing the magnetic material particles and that the frequency of the high-frequency signal used to determine the electric field attenuation and the magnetic field attenuation was changed to 2 GHz.

The imaginary part µ" of the complex relative magnetic permeability µ of an electromagnetic wave absorption film was measured as follows.

The measurement devices used were a vector network analyzer (product name: N5225B) available from Keysight and horn antennas (product names: RH12S23 and RH06S10) available from KEYCOM Corporation. A free space method was used to measure the S parameters. Specifically, the incident angle was set to 0°, and the sweep frequency range was set to 55.0 GHz to 95.0 GHz. The electromagnetic wave absorption film was disposed such that one flat surface was directed to the incident side, and the S parameters were measured at 0.1 GHz intervals. Then the imaginary part µ" of the complex relative magnetic permeability µ at 60 GHz was determined. Next, the sweep frequency range was changed, and the imaginary part µ" of the complex relative magnetic permeability µ was determined at 28 GHz and 47 GHz.

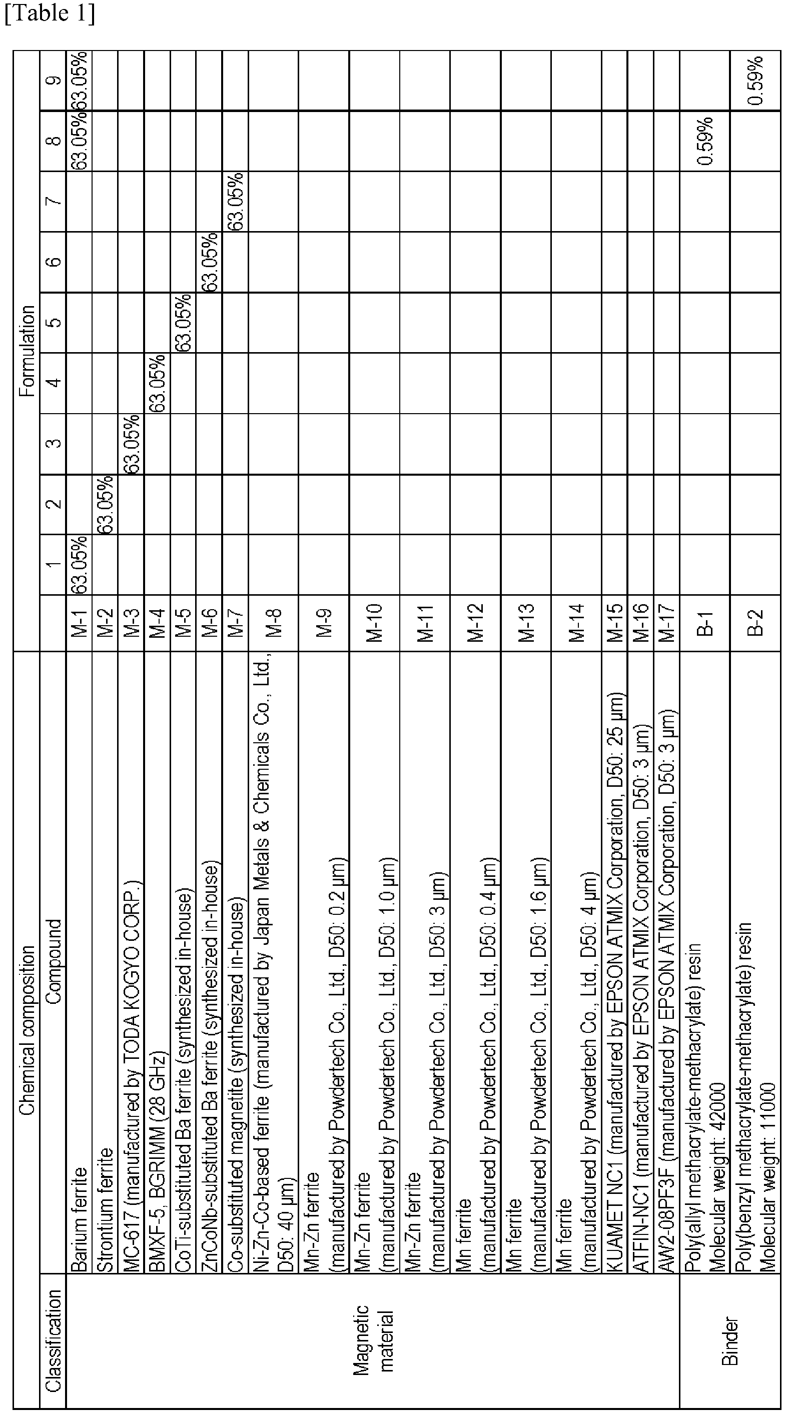

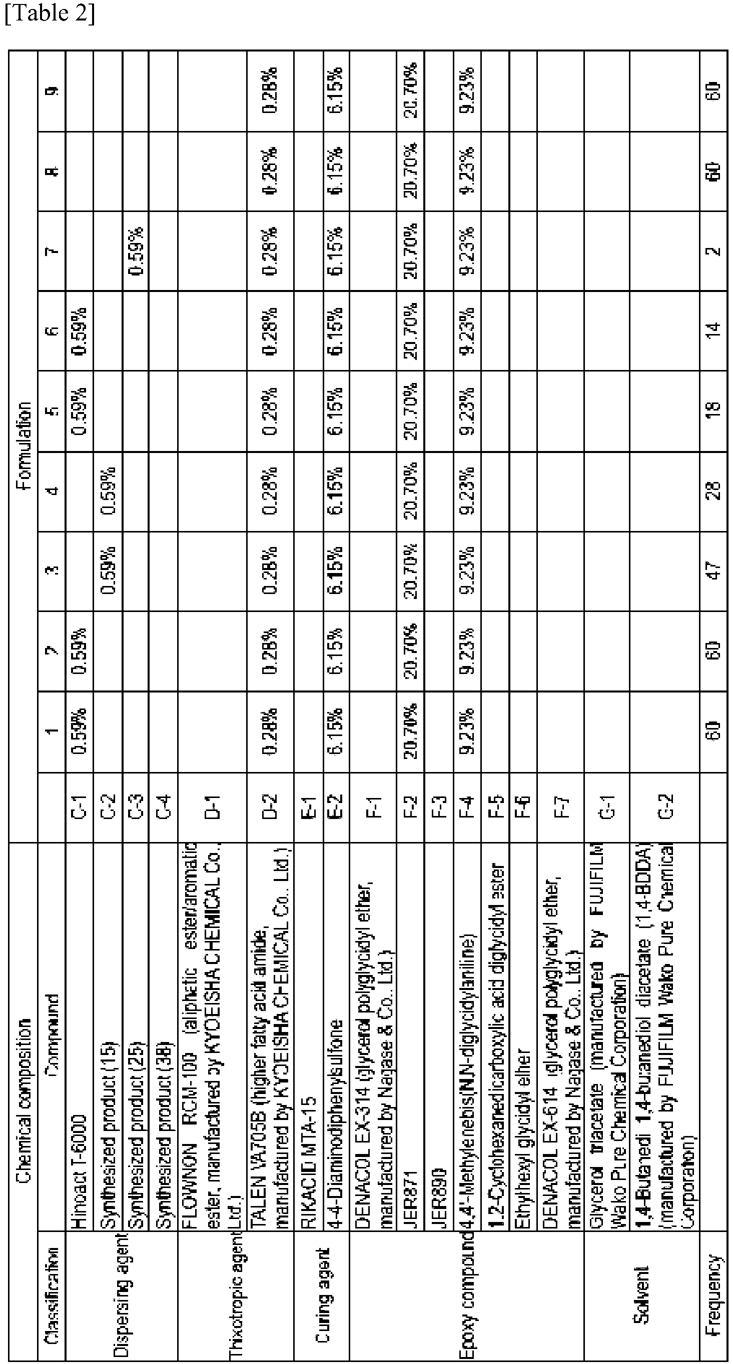

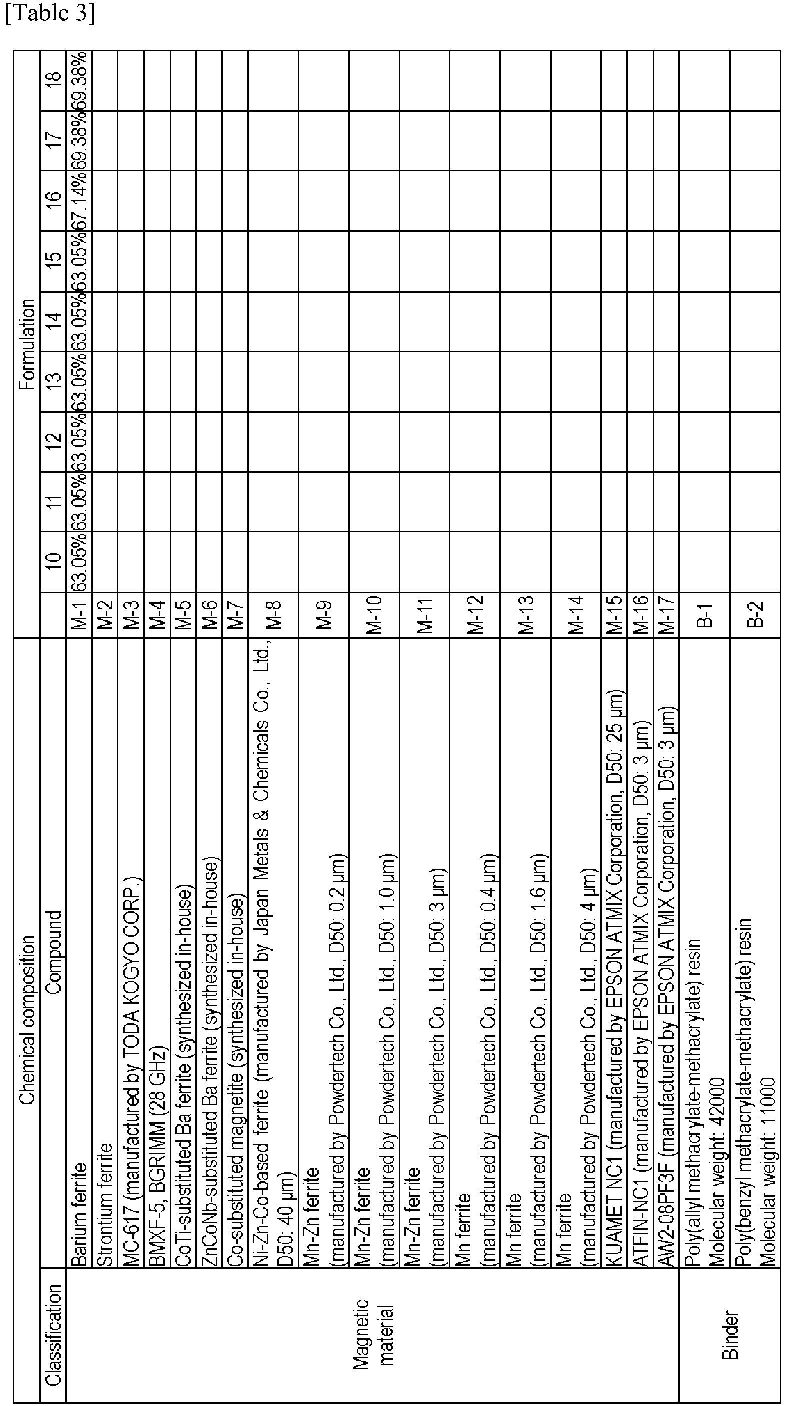

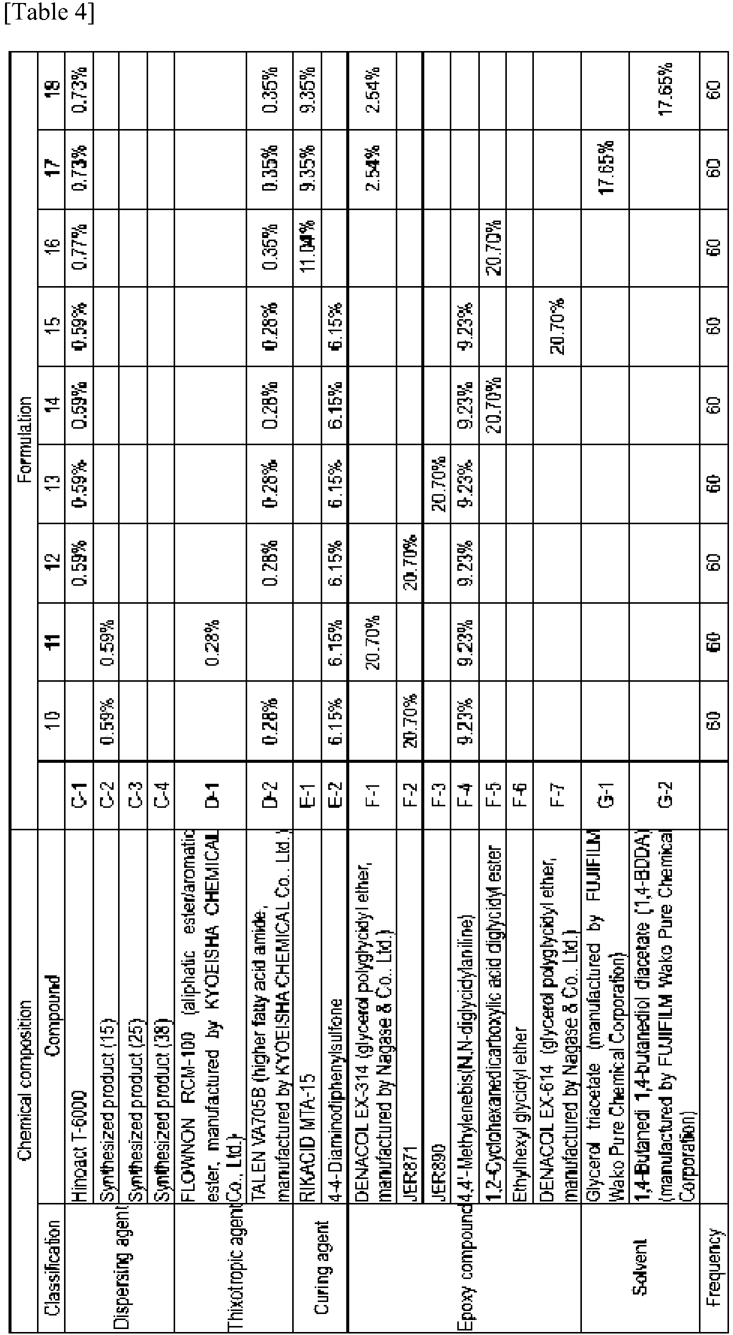

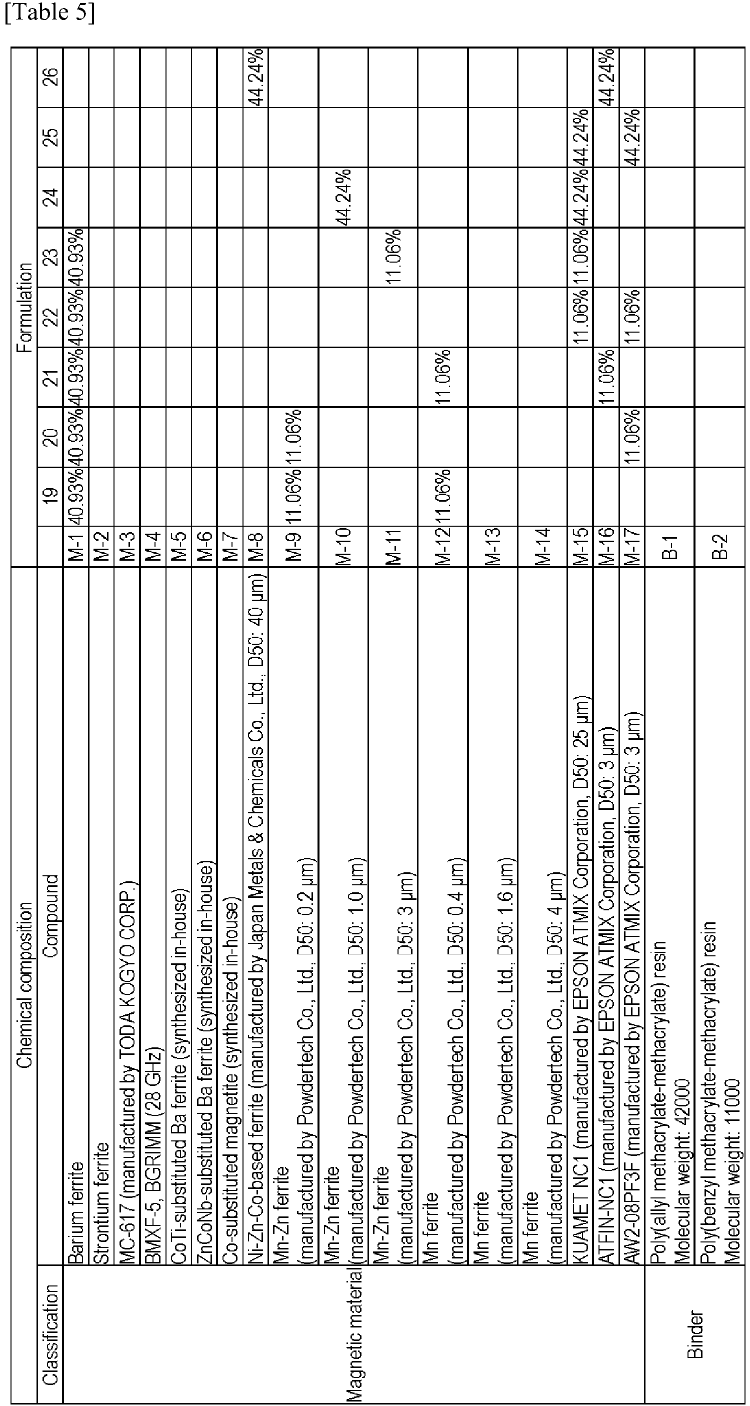

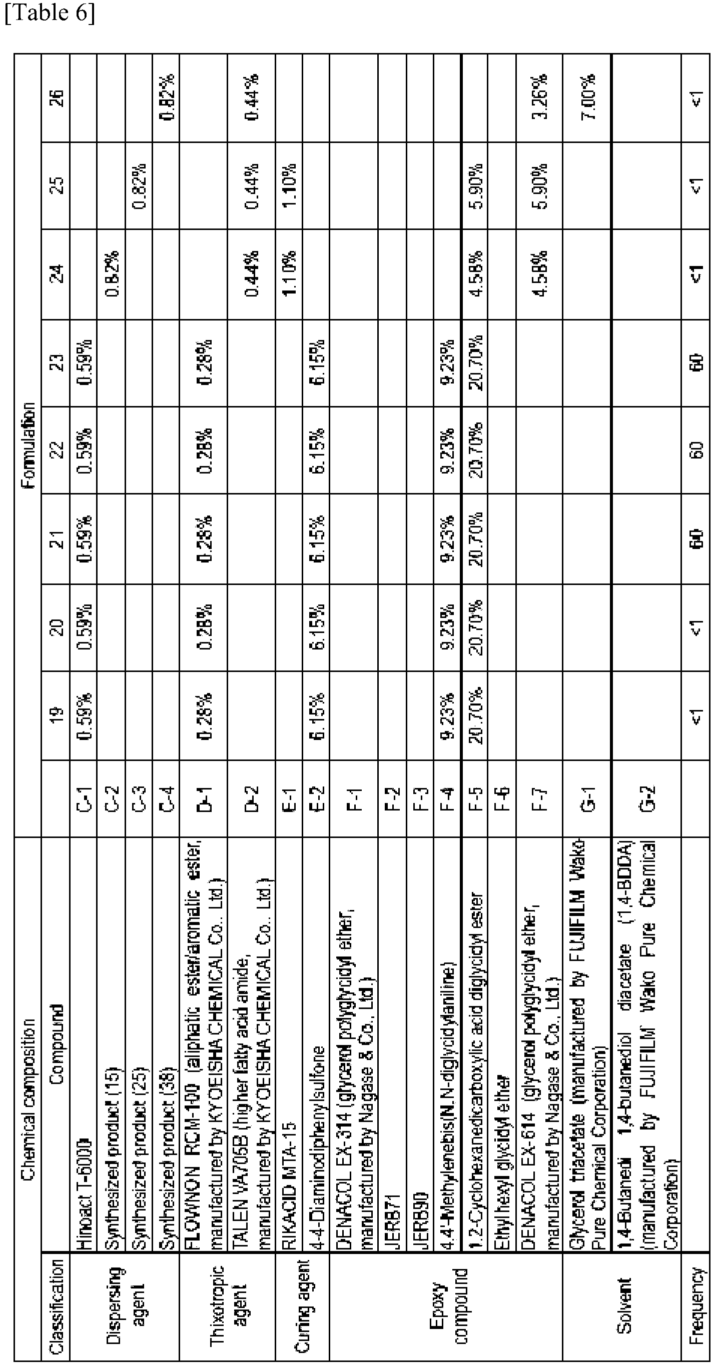

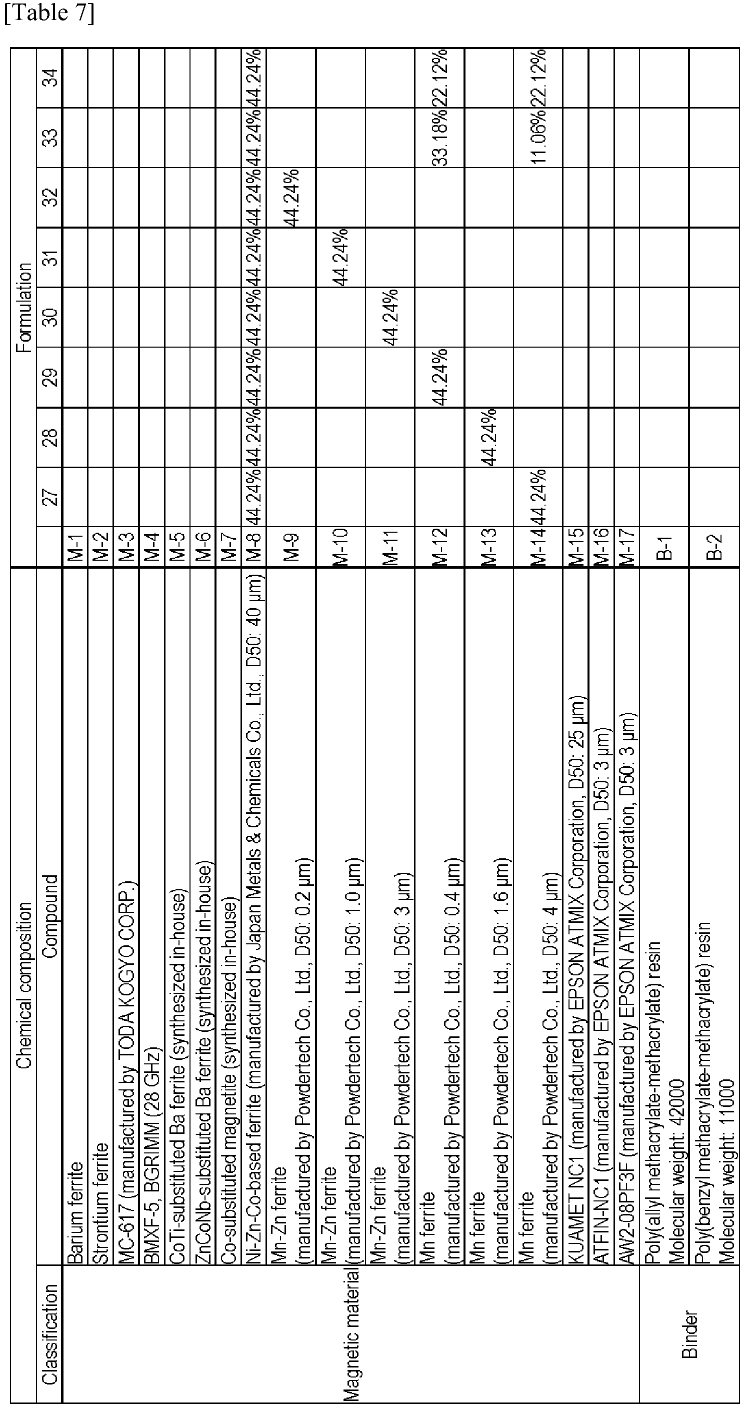

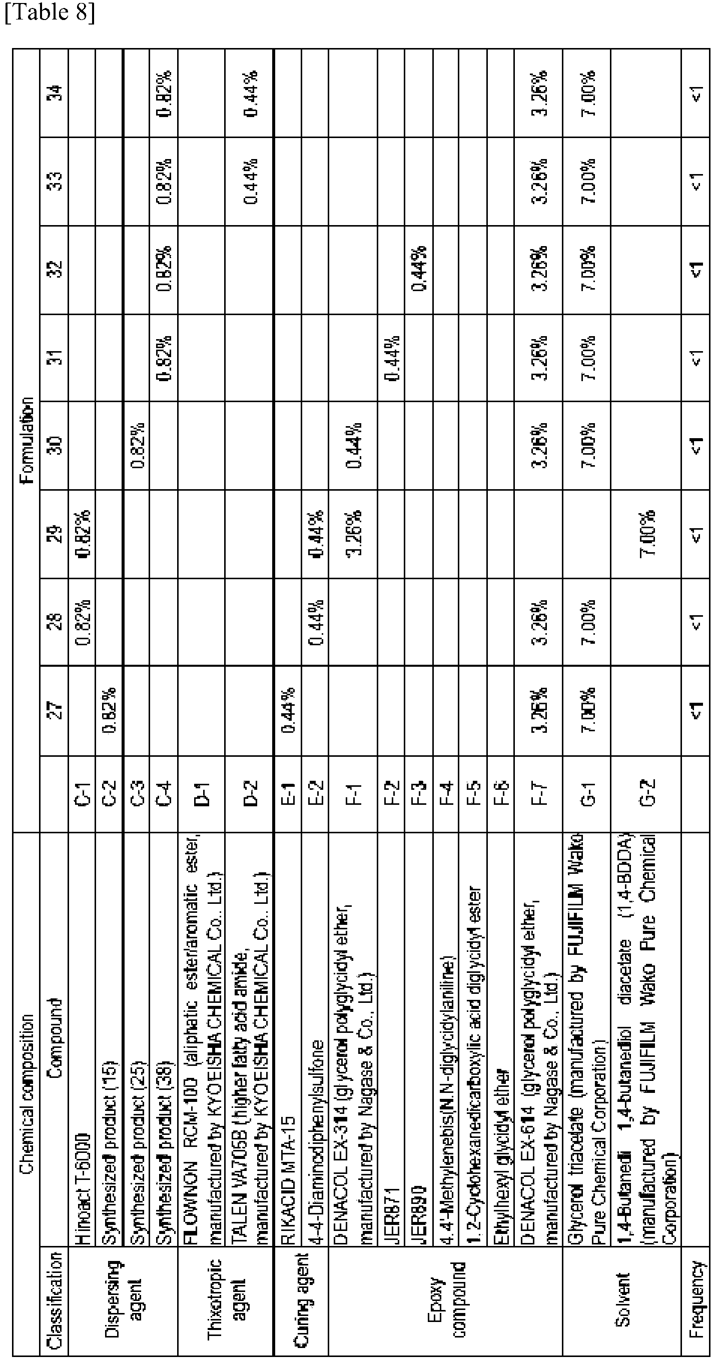

**[Table 9]**

| | Formulation | Shape | Frequency (GHz) | Electromagnetic wave shielding ability | Far field gain |
|---|---|---|---|---|---|
| Example 1 | 1 | 1 | 60 | A | A |
| Example 2 | 2 | 1 | 60 | A | A |
| Example 3 | 3 | 1 | 47 | A | A |
| Example 4 | 4 | 1 | 28 | A | A |
| Example 5 | 5 | 1 | 18 | A | A |
| Example 6 | 6 | 1 | 14 | A | A |
| Example 7 | 7 | 1 | 2 | A | A |
| Example 8 | 8 | 1 | 60 | A | A |
| Example 9 | 9 | 1 | 60 | A | A |
| Example 10 | 10 | 1 | 60 | A | A |
| Example 11 | 11 | 1 | 60 | A | A |
| Example 12 | 12 | 1 | 60 | A | A |
| Example 13 | 13 | 1 | 60 | A | A |
| Example 14 | 14 | 1 | 60 | A | A |
| Example 15 | 15 | 1 | 60 | A | A |
| Example 16 | 16 | 1 | 60 | A | A |
| Example 17 | 17 | 1 | 60 | A | A |
| Example 18 | 18 | 1 | 60 | A | A |
| Example 19 | 1 | 2 | 60 | C | A |
| Example 20 | 2 | 2 | 60 | C | A |
| Example 21 | 3 | 2 | 47 | C | A |
| Example 22 | 4 | 2 | 28 | C | A |
| Example 23 | 5 | 2 | 18 | C | A |
| Example 24 | 6 | 2 | 14 | C | A |
| Example 25 | 7 | 2 | 2 | C | A |
| Example 26 | 1 | 3 | 60 | A | C |
| Example 27 | 2 | 3 | 60 | A | C |
| Example 28 | 3 | 3 | 47 | A | C |
| Example 29 | 4 | 3 | 28 | A | C |
| Example 30 | 5 | 3 | 18 | A | C |
| Example 31 | 6 | 3 | 14 | A | C |
| Example 32 | 7 | 3 | 2 | A | C |
| Example 33 | 1 | 4 | 60 | B | A |
| Example 34 | 2 | 4 | 60 | B | A |
| Example 35 | 3 | 4 | 47 | B | A |
| Example 36 | 4 | 4 | 28 | B | A |
| Example 37 | 5 | 4 | 18 | B | A |
| Example 38 | 6 | 4 | 14 | B | A |
| Example 39 | 7 | 4 | 2 | B | A |

**[Table 10]**

| | Formulation | Shape | Frequency (GHz) | Electromagnetic wave shielding ability | Far field gain |
|---|---|---|---|---|---|
| Comparative Example 1 | - | 5 | 60 | D | A |
| Comparative Example 2 | - | 5 | 47 | D | A |
| Comparative Example 3 | - | 5 | 28 | D | A |
| Comparative Example 4 | - | 5 | 18 | D | A |
| Comparative Example 5 | - | 5 | 14 | D | A |
| Comparative Example 6 | - | 5 | 2 | D | A |
| Comparative Example 7 | 1 | 6 | 60 | B | D |
| Comparative Example 8 | 2 | 6 | 60 | B | D |
| Comparative Example 9 | 3 | 6 | 47 | B | D |
| Comparative Example 10 | 4 | 6 | 28 | B | D |
| Comparative Example 11 | 5 | 6 | 18 | B | D |
| Comparative Example 12 | 6 | 6 | 14 | B | D |
| Comparative Example 13 | 7 | 6 | 2 | B | D |
| Comparative Example 14 | 1 | 7 | 60 | A | D |
| Comparative Example 15 | 2 | 7 | 60 | A | D |
| Comparative Example 16 | 3 | 7 | 47 | A | D |
| Comparative Example 17 | 4 | 7 | 28 | A | D |
| Comparative Example 18 | 5 | 7 | 18 | A | D |
| Comparative Example 19 | 6 | 7 | 14 | A | D |
| Comparative Example 20 | 7 | 7 | 2 | A | D |
| Comparative Example 21 | 1 | 8 | 60 | D | B |
| Comparative Example 22 | 2 | 8 | 60 | D | B |
| Comparative Example 23 | 3 | 8 | 47 | D | B |
| Comparative Example 24 | 4 | 8 | 28 | D | B |
| Comparative Example 25 | 5 | 8 | 18 | D | B |
| Comparative Example 26 | 6 | 8 | 14 | D | B |
| Comparative Example 27 | 7 | 8 | 2 | D | B |

As shown in Tables 9 and 10, both the electromagnetic wave shielding ability and the far field gain were favorable in Examples 1 to 39, unlike in Comparative Examples 1 to 27. As described above, in Examples 1 to 39, the antenna gain of the transmitting antenna element was higher than that in Comparative Examples 1 to 27, and the electromagnetic field influence between the transmitting antenna element and the receiving antenna element was smaller.

In Comparative Examples 1 to 27, one of the electromagnetic wave shielding ability or the far field gain was poor, and the electromagnetic wave shielding ability and the far field gain were not satisfactory at the same time.

As can be seen in Examples 1 to 39, the electromagnetic wave shielding ability and far field gain of shape 1 were both high.

Shape 4 showed good performance, following shape 1. Shape 3 differs from shape 4 in that the arrangement position of the magnetic material layer in shape 3 was on the front surface of the substrate, whereas that in shape 4 was on the back surface. It was found to be more preferable to dispose the magnetic material layer on the back surface of the substrate.

### Reference Signs List

10, 10a, 10b, 10c, 10d, 10e structure
20 substrate
20a, 32a, 102a front surface
20b, 28b back surface
20c region
22 transmitting antenna element
22a feeding point
24 receiving antenna element
25 through hole
26, 32, 102, 106 magnetic material portion
27 composition
28 interposer
29 circuit board
29c, 42 connection terminal
30 magnetic material wall portion
32c region
34 magnetic material layer
34a first magnetic material portion
34b second magnetic material portion
34c third magnetic material portion
34d fourth magnetic material portion
34e end portion
35a, 35b gap
37, 38 wiring line
40 wiring line layer
44 solder ball
45 underfill layer
100, 100a, 100b structure
103 first opening portion
104 second opening portion
105 concave section
105c bottom surface
D₃, D₁₀, D₁₁ distance
Dt thickness direction
Dx one direction
Dy another direction

## Claims

1. A structure comprising:
a substrate;
a transmitting antenna element and a receiving antenna element that are disposed on one surface of the substrate; and
a plurality of magnetic material portions extending in a thickness direction of the substrate within the substrate and disposed so as to be spaced apart from each other.

2. The structure according to claim 1, wherein, when the substrate is viewed in a direction normal to the one surface of the substrate, the magnetic material portions are arranged around the transmitting antenna element and around the receiving antenna element.

3. A structure comprising:
a substrate;
a transmitting antenna element and a receiving antenna element that are disposed on one surface of the substrate;
a magnetic material wall portion disposed on the one surface of the substrate and arranged in a region excluding a region including the transmitting antenna element and the receiving antenna element so as to surround the transmitting antenna element and the receiving antenna element; and
a magnetic material portion disposed on another surface of the substrate.

4. The structure according to claim 3, wherein the magnetic material portion is disposed so as to cover an entire surface on the another surface of the substrate.

5. The structure according to claim 1 or 3, wherein the magnetic material portion contains magnetic material particles.

6. A structure comprising:
a substrate;
a transmitting antenna element and a receiving antenna element that are disposed on one surface of the substrate; and
a magnetic material layer disposed on the substrate,
wherein, when the substrate is viewed in a direction normal to the one surface of the substrate, the magnetic material layer has
a first magnetic material portion disposed between the transmitting antenna element and the receiving antenna element,
a second magnetic material portion disposed so as to sandwich the transmitting antenna element together with the first magnetic material portion,
a third magnetic material portion disposed so as to sandwich the receiving antenna element together with the first magnetic material portion, and
a fourth magnetic material portion connecting the first magnetic material portion, the second magnetic material portion, and the third magnetic material portion, and
wherein the fourth magnetic material portion is disposed so as to avoid a region in which the transmitting antenna element is disposed and a region in which the receiving antenna element is disposed.

7. The structure according to claim 6, wherein the magnetic material layer is disposed on the one surface of the substrate.

8. The structure according to claim 6, wherein the magnetic material layer is disposed on another surface of the substrate.

9. The structure according to claim 6, wherein, in the magnetic material layer, the first magnetic material portion, the second magnetic material portion, and the third magnetic material portion are linear members extending in a one direction,
wherein the fourth magnetic material portion is a linear member extending in a another direction orthogonal to the one direction,
wherein the first magnetic material portion, the second magnetic material portion, and the third magnetic material portion are spaced apart from each other and disposed parallel to each other, and
wherein the fourth magnetic material portion connects the first magnetic material portion, the second magnetic material portion, and the third magnetic material portion at their end portions with respect to the one direction.

10. The structure according to claim 6, wherein the magnetic material layer contains magnetic material particles.

11. The structure according to claim 1 or 3, wherein the magnetic material portion has a complex relative magnetic permeability µ with a real part µ' and an imaginary part µ", and
the imaginary part µ" is 0.01 to 10 at a frequency of 1 to 40 GHz and is 0.01 to 5 at a frequency of higher than 40 GHz and 100 GHz or less.

12. The structure according to claim 6, wherein the magnetic material layer has a complex relative magnetic permeability µ with a real part µ' and an imaginary part µ", and
the imaginary part µ" is 0.01 to 10 at a frequency of 1 to 40 GHz and is 0.01 to 5 at a frequency of higher than 40 GHz and 100 GHz or less.

13. The structure according to claim 1, further comprising an interposer stacked on the substrate.

14. The structure according to claim 5, wherein the magnetic material particles contain at least one metal element selected from the group consisting of Ni, Co, and Fe and have a number average particle diameter of 20 nm to 50 µm.

15. The structure according to claim 10, wherein the magnetic material particles contain at least one metal element selected from the group consisting of Ni, Co, and Fe and have a number average particle diameter of 20 nm to 50 µm.

16. A method for producing a structure, the method comprising the steps of:
forming, in a substrate, a plurality of through holes passing through the substrate in a thickness direction thereof;
filling the through holes with magnetic material particles; and
forming a transmitting antenna element and a receiving antenna element on the substrate.
